(19) Europäisches Patentamt / European Patent Office / Office européen des brevets

(11) EP 3 395 894 B1

(12) # EUROPEAN PATENT SPECIFICATION

(45) Date of publication and mention of the grant of the patent:
**15.04.2020 Bulletin 2020/16**

(21) Application number: **16879001.2**

(22) Date of filing: **22.12.2016**

(51) Int Cl.:
***C09K 19/38*** *(2006.01)* ***C09K 5/14*** *(2006.01)*
***C08G 63/193*** *(2006.01)* ***C09K 19/34*** *(2006.01)*
***C08L 67/02*** *(2006.01)* ***C09K 19/52*** *(2006.01)*
***C08K 3/22*** *(2006.01)* ***C08L 67/00*** *(2006.01)*

(86) International application number:
**PCT/JP2016/088537**

(87) International publication number:
**WO 2017/111115 (29.06.2017 Gazette 2017/26)**

(54) **RESIN COMPOSITION AND ADHESIVE SHEET**

HARZZUSAMMENSETZUNG UND KLEBEFOLIE

COMPOSITION DE RÉSINE ET FEUILLE ADHÉSIVE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2015 JP 2015251234**
**08.02.2016 JP 2016022069**

(43) Date of publication of application:
**31.10.2018 Bulletin 2018/44**

(73) Proprietor: **Kaneka Corporation**
**Osaka-shi, Osaka 530-8288 (JP)**

(72) Inventors:
- **YOSHIHARA, Shusuke**
  **Settsu-shi**
  **Osaka 566-0072 (JP)**
- **ANDO, Takashi**
  **Settsu-shi**
  **Osaka 566-0072 (JP)**

(74) Representative: **Vossius & Partner**
**Patentanwälte Rechtsanwälte mbB**
**Siebertstrasse 3**
**81675 München (DE)**

(56) References cited:
**WO-A1-2011/033815**
**WO-A1-2015/083523**
**JP-A- 2007 254 724**
**JP-A- 2015 183 033**
**KR-A- 20090 088 873**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 395 894 B1

**Description**

TECHNICAL FIELD

The present invention relates to a resin composition and an adhesive sheet using the resin composition. Specifically, the present invention relates to a liquid crystal polymer composition which is suitable for forming a semi-cured thermally conductive film that has excellent thermal conductivity, bondability, and low-temperature processability, and can be used for a circuit board.

The present invention further relates to a curable resin composition which has bonding strength in addition to high thermal conductivity. The present invention further relates to a resin composition which contains a thermally conductive organic additive, has excellent thermal conductivity, and is capable of imparting thermal conductivity to plastics. More specifically, the present invention relates to a resin composition having both the high thermal conductivity and favorable molding processability and insulating property due to a synergistic effect between the high thermal conductivity caused by a matrix resin and the high filling of a thermally conductive inorganic filler like ceramic, metal, and carbon material.

BACKGROUND ART

A resin composition used for various kinds of electric and electronic instruments is required to have excellent thermal conductivity. Specifics are as described in the following background technology 1 and 2.

• Background technology 1

An amount of heat generated from a highly densified conductor tends to increase in accordance with a progress of miniaturization of electric and electronic instruments such as motors, power generators, print wiring boards, or IC chips. Due to such reasons, it is required to increase the thermal conductivity of a thermal interface material (TIM) used for electric and electronic instruments. As a TIM used for electric and electronic instruments, a resin material like epoxy resin which has excellent heat resistance, moisture resistance, moldability, bondability, or the like is widely used. However, because the resin material generally has low thermal conductivity and it remains as a huge problem of interfering heat dissipation, development of a cured resin product having high thermal conductivity is required. As a means for achieving the high thermal conductivity, there is a method in which a thermal conductive filler consisting of highly-thermal conductive ceramics is filled in a resin composition to give a composite material. As for the highly-thermal conductive ceramics, alumina, boron nitride, aluminum nitride, silica, silicon nitride, magnesium oxide, silicon carbide, graphite, and the like are known.

Furthermore, as another method for achieving the high thermal conductivity of a resin composition, a method of obtaining high thermal conductivity of a resin itself by using a liquid crystal resin having mesogen skeleton is considered in Patent Document 1, for example. However, not enough descriptions are given in the Document relating to specific use, and there is no description regarding a resin composition focused on specific use like a semi-cured thermally conductive film that is used for an electronic circuit board, for example.

• Background technology 2

When a thermoplastic resin composition is used for various applications like a case body for a PC or a display, an electronic device material, an automotive interior/exterior material, or the like, plastics sometimes have a problem that generated heat is not easily released as they have lower thermal conductivity compared to an inorganic material like metallic material. To solve such problem, an attempt has been widely made to obtain a highly-thermal conductive resin composition by blending a large amount of a highly-thermal conductive inorganic material in thermoplastic resin. As for the highly-thermal conductive inorganic compound, it is necessary that a highly-thermal conductive inorganic material such as graphite, carbon fiber, alumina, or boron nitride is blended at high content, that is, 30% by volume or more, or 50% by volume or more, in resin. However, when graphite or carbon fiber as an inorganic material is blended in a large amount, the electric insulating property of a resin is impaired to exhibit conductivity, and thus there is a problem that the area in which the resin can be used is limited in terms of use in an electronic instrument. Furthermore, when a ceramic filler like alumina is blended in large amount, due to high hardness of a filler, mold wear is caused when it is used as a material for molding or the like. Furthermore, due to high density of a filler, the obtained composition has high density, and thus there is a problem that the processability is impaired and it is difficult to have an electronic instrument having light weight. Furthermore, due to the low thermal conductivity of a resin itself, there is a limit to the enhancement of thermal conductivity of a resin composition even when an inorganic material is blended in a large amount. Accordingly, there is a demand for a method to enhance the thermal conductivity of a resin itself.

With regard to a thermoplastic resin, it is described in Patent Document 2 that, by orienting a liquid crystal polyester by using at least one of external field selected from a flow field, a shear field, a magnetic field, and an electric field, a resin molded article having high thermal conductivity in the orientation direction of the liquid crystal polyester is obtained. However, although this resin molded article has high thermal conductivity in 1-axial direction, it has low thermal conductivity in other 2-axial direction. Furthermore, when it is desired to have orientation using a magnetic field, for example, to obtain desired thermal conductivity, magnetic flux density of at least 3 Tesla is required. Due to such reasons, it is difficult to manufacture such resin molded article.
Patent Document 3 relates to a specific resin material for heat dissipation or heat transfer.

Patent Document 1: PCT International Publication No. WO2011/033815
Patent Document 2: Japanese Unexamined Patent Application, Publication No. 2008-150525
Patent Document 3: PCT International Publication No. WO 2015/083523

## DISCLOSURE OF THE INVENTION

### Problems to be Solved by the Invention

An object of the present invention is to provide a resin composition having excellent thermal conductivity. In particular, with regard to the background technology 1, an object of the present invention is to provide a liquid crystal polymer composition which is suitable for forming a semi-cured thermally conductive film that has excellent thermal conductivity, bondability, and low-temperature processability, and a circuit board which uses this liquid crystal polymer composition. In addition, with regard to the background technology 2, an object of the present invention is to provide a curable resin composition which has bonding strength in addition to the high thermal conductivity.

### Means for Solving the Problems

To achieve the object described above, particularly with regard to the background technology 1, the inventors of the present invention studied a composition containing (I) a compound having two or more epoxy groups in the molecule, (II) a curing agent, (III) a liquid crystal polymer that forms a liquid crystal phase at 190°C or lower, (IV) a thermal conductive filler, and (V) a solvent.
Furthermore, with regard to the background technology 2, the inventors of the present invention studied a curable resin composition containing the following (A), (B), (C), (D), and (E), and completed the present invention accordingly.

(A) a thermoplastic resin having a specific structure; (B) a curable resin; (C) a curing agent; (D) an elastomer; and (E) an inorganic filler. Namely, the present invention is as defined in the claims.

### Effects of the Invention

According to the present invention, a resin composition with excellent thermal conductivity can be provided. More specifically, with the resin composition of the present invention as a liquid crystal polymer composition, a semi-cured thermally conductive film having excellent thermal conductivity, bondability, and low-temperature processability can be formed, and a circuit board which uses this liquid crystal polymer composition has an excellent heat dissipation property. According to the resin composition of the present invention as a curable resin composition, the resin itself has high thermal conductivity, flexibility, and can provide a curable resin molded article in which an inorganic filler is filled at high level. As such, according to the present invention, due to a synergistic effect of the high filling of a thermally conductive resin composition and a thermally conductive inorganic filler, the effect of providing a resin material and a thermally conductive adhesive sheet for heat dissipation · heat transfer while maintaining the bonding strength and achieving the high thermal conductivity is exhibited.

## PREFERRED MODE FOR CARRYING OUT THE INVENTION

The resin composition according to the present invention contains the curable compound ($\alpha$), the curing agent ($\beta$), the liquid crystal polymer ($\gamma$) that forms a liquid crystal phase at 190°C or lower, and the filler ($\delta$). It is to be noted that the resin composition of the present invention is required to comprise each of the components (A), (B), (C), (D) and (E) as defined in the follwoing. The curable compound ($\alpha$) is not particularly limited, and examples thereof include (I) a compound having two or more epoxy groups in the molecule and (B) a curable resin. The curing agent ($\beta$) is not particularly limited, and examples thereof include (II) a curing agent and (C) the curing agent. The liquid crystal polymer ($\gamma$) that

forms a liquid crystal phase at 190°C or lower is not particularly limited, and examples thereof include (III) a liquid crystal polymer that forms a liquid crystal phase at 190°C or lower and (A) a thermoplastic resin with specific structure that is described later. The filler (δ) is not particularly limited, and examples thereof include (IV) a thermal conductive filler and (E) an inorganic filler. Each of the curable compound (α), the curing agent (β), the liquid crystal polymer (γ) that forms a liquid crystal phase at 190°C or lower, and the filler (δ) may be used either singly or in combination of two or more types thereof. The resin composition according to the present invention is the curable resin composition that is described in the following second embodiment. Hereinbelow, the first embodiment related to the background technology 1 and the second embodiment related to the background technology 2 are described, in particular.

• First Embodiment (for reference)

The liquid crystal polymer composition contains (I) the compound having two or more epoxy groups in the molecule, (II) the curing agent, (III) the liquid crystal polymer that forms a liquid crystal phase at 190°C or lower, (IV) the thermal conductive filler, and (V) a solvent.

Examples of (I) the epoxy compound having two epoxy groups in the molecule that is used in the present disclosure (hereinbelow, epoxy compound (I)) include bisphenol A type epoxy resin that is synthesized by a reaction between bisphenol A and epichlorohydrin or the like, bisphenol F type epoxy resin that is synthesized by the same reaction, novolac type epoxy resin that is synthesized by a reaction between novolac resin and epichlorohydrin or the like, a glycidyl ether compound that is synthesized by a reaction between polyvalent aliphatic, alicyclic, aromatic alcohol and epichlorohydrin, an epoxy compound obtained by epoxidation of an aliphatic or alicyclic compound having plural unsaturated groups with acetic acid and peracetic acid, a glycidyl amine compound that is synthesized by a reaction between polyvalent aliphatic, alicyclic, aromatic amine and epichlorohydrin, and an epoxy compound that is synthesized by a reaction between a compound having plural nitrogen-containing heterocycles and eipchlorohydrin or the like.

If there are less than two epoxy groups contained in a molecule of (I) the epoxy compound, a cross-linked structure cannot be formed so that heat resistance of a cured product is not expected.

Specific examples of (I) the epoxy compound include, as those having amines as a precursor, tetraglycidyldiaminodiphenylmethane, glycidyl compound of xylenediamine, triglycidylaminophenol, and each positional isomer or a product having substitution at alkyl group or halogen of glycidylaniline.

Examples of a commercially available product of tetraglycidyldiaminodiphenylmethane include "SUMI-EPOXY" ELM434 (manufactured by Sumitomo Chemical Company, Limited), "Araldite" MY720, "Araldite" MY721, "Araldite" MY9512, "Araldite" MY9612, "Araldite" MY9634, "Araldite" MY9663 (all manufactured by Huntsman Advanced Materials LLC), and "jER" (registered trademark, ditto in the followings) 604 (manufactured by Mitsubishi Chemical Corporation) .

Examples of a commercially available product of triglycidylaminophenol include "jER" 630 (manufactured by Mitsubishi Chemical Corporation), "Araldite" MY0500, MY0510 (all manufactured by Huntsman Advanced Materials LLC) and ELM100 (manufactured by Sumitomo Chemical Company, Limited). Examples of a commercially available product of glycidylanilines include GAN and GOT (all manufactured by Nippon Kayaku Co., Ltd.).

Examples of the glycidyl ether type epoxy compound having phenol as a precursor include a bisphenol A type epoxy resin, a bisphenol F type epoxy resin, a bisphenol S type epoxy resin, an epoxy resin having biphenyl skeleton, a phenol novolac type epoxy resin, a cresol novolac type epoxy resin, a resorcinol type epoxy resin, an epoxy resin having naphthalene skeleton, a trisphenylmethane type epoxy resin, a phenolaralkyl type epoxy resin, a dicyclopentadiene type epoxy resin, a diphenylfluorene type epoxy resin, and various isomers or products having substitution at alkyl group or halogen of each of them. Furthermore, an epoxy resin obtained by modifying an epoxy resin having phenol as a precursor with urethane or isocyanate is also included in this type.

Examples of a commercially available product of liquid phase bisphenol A type epoxy resin include "jER" 825, "jER" 826, "jER" 827, "jER" 828, (all manufactured by Mitsubishi Chemical Corporation), "EPICLON" 850 (manufactured by DIC Corporation), "Epotohto" YD-128 (manufactured by Nippon Steel Chemical Co., Ltd.), and DER-331 and DER-332 (manufactured by The Dow Chemical Company).

Examples of a commercially available product of solid or semi-solid bisphenol A type epoxy resin include "jER" 834, "jER" 1001, "jER" 1002, "jER" 1003, "jER" 1004, "jER" 1004AF, "jER" 1007, "jER" 1009, "jER" 1010, and "jER" 1256 (all manufactured by Mitsubishi Chemical Corporation).

Examples of a commercially available product of liquid phase bisphenol F type epoxy resin include "jER" 806, "jER" 807, "jER" 1750, "jER"(all manufactured by Mitsubishi Chemical Corporation), "EPICLON" 830 (manufactured by DIC Corporation), and "Epotohto" YD-170 and "Epotohto" YD-175 (all manufactured by Nippon Steel Chemical Co., Ltd.).

Examples of a commercially available product of solid bisphenol F type epoxy resin include 4004P, "jER" 4007P, "jER" 4009P (all manufactured by Mitsubishi Chemical Corporation), and "Epotohto" YDF2001 and "Epotohto" YDF2004 (all manufactured by Nippon Steel Chemical Co., Ltd.).

Examples of bisphenol S type epoxy resin include EXA-1515 (manufactured by DIC Corporation).

Examples of a commercially available product of the epoxy resin having biphenyl skeleton include "jER"

YX4000H, "jER" YX4000, and "jER" YL6616 (all manufactured by Mitsubishi Chemical Corporation) and NC-3000 (manufactured by Nippon Kayaku Co., Ltd.).

Examples of a commercially available product of the phenol novolac type epoxy resin include "jER" 152 and "jER" 154 (all manufactured by Mitsubishi Chemical Corporation), and "EPICLON" N-740, "EPICLON" N-770, and "EPICLON" N-775 (all manufactured by DIC Corporation). Examples of a commercially available product of the cresol novolac type epoxy resin include "EPICLON" N-660, "EPICLON" N-665, "EPICLON" N-670, "EPICLON" N-673, and "EPICLON" N-695 (all manufactured by DIC Corporation), and EOCN-1020, EOCN-102S, and EOCN-104S (all manufactured by Nippon Kayaku Co., Ltd.). Examples of a commercially available product of the resorcinol type epoxy resin include "Denacol" EX-201 (manufactured by Nagase ChemteX Corporation).

Examples of a commercially available product of the epoxy resin having naphthalene skeleton include "EPICLON" HP4032 (manufactured by DIC Corporation), and NC-7000 and NC-7300 (all manufactured by Nippon Kayaku Co., Ltd.).

Examples of a commercially available product of the trisphenylmethane type epoxy resin include TMH-574 (manufactured by Sumitomo Chemical Company, Limited).

Examples of a commercially available product of the dicyclopentadiene type epoxy resin include "EPICLON" HP7200, "EPICLON" HP7200L, "EPICLON" HP7200H (all manufactured by DIC Corporation), "Tactix" 558 (manufactured by Huntsman Advanced Materials LLC), and XD-1000-1L and XD-1000-2L (all manufactured by Nippon Kayaku Co., Ltd.).

Examples of a commercially available product of the epoxy resin modified with urethane and isocyanate include AER4152 having an oxazolidone ring (manufactured by Asahi Kasei E-materials Corporation). Examples of the epoxy resin having carboxylic acid as a precursor include a glycidyl compound of phthalic acid, a glycidyl compound of hexahydrophthalic acid, dimer acid, and various isomers of each of them.

Examples of a commercially available product of the phthalic acid diglycidyl ester include "Epomic" R508 (manufactured by Mitsui Chemicals Inc.) and "Denacol" EX-721 (manufactured by Nagase ChemteX Corporation).

Examples of a commercially available product of the hexahydrophthalic acid diglycidyl ester include "Epomic" R540 (manufactured by Mitsui Chemicals Inc.) and AK-601 (manufactured by Nippon Kayaku Co., Ltd.). Examples of a commercially available product of the dimer acid diglycidyl ester include "jER" 871 (manufactured by Mitsubishi Chemical Corporation) and "Epotohto" YD-171 (manufactured by Nippon Steel Chemical Co., Ltd.).

Examples of the epoxy resin having intramolecular unsaturated carbon as a precursor include an alicyclic epoxy resin.

Specifically, examples of a commercially available product of (3',4'-epoxycyclohexane)methyl-3,4-epoxycyclohexanecarboxylate include "Celloxide" 2021P (manufactured by Daicel Chemical Industries, Ltd.), and CY179 (manufactured by Huntsman Advanced Materials LLC), examples of a commercially available product of (3',4'-epoxycyclohexane)octyl 3,4-epoxycyclohexanecarboxylate include "Celloxide" 2081 (manufactured by Daicel Chemical Industries, Ltd.), and examples of a commercially available product of 1-methyl-4-(2-methyloxiranyl)-7-oxabicyclo[4.1.0]heptane include "Celloxide" 3000 (manufactured by Daicel Chemical Industries, Ltd.) .

According to a reaction with (I) the epoxy compound, (II) the curing agent forms a cross-linked structure. As (II) the curing agent is contained, (I) the epoxy compound reacts with (II) the curing agent so that their reaction with (III) the liquid crystal polymer is suppressed. Based on this, it is considered that an orderly aligned structure in which (III) the liquid crystal polymer independently becomes a thermally conductive path is formed and high thermal conductivity of a cured product is yielded. As for (II) the curing agent, one or a mixture of two or more kinds of aromatic amines such as diethyltoluenediamine, metaphenylenediamine, diaminodiphenylmethane, diaminodiphenylsulfon, metaxylenediamine, or various derivatives thereof, aliphatic amines such as triethylene tetramine or isophorone diamine, imidazole derivatives such as imidazole, 2-methylimidazole, 2-ethylimidazole, 2-ethyl-4-methylimidazole, 4-methylimidazole, 2-phenylimidazole, 2-phenyl-4-methylimidazole, 1-benzyl-2-methylimidazole, 1-benzyl-2-ethyl-5-methylimidazole, or 2-phenyl-3-methyl-5-hydroxymethylimidazole, carboxylic acid anhydrides such as 1,8-diazabicyclo(5,4,0)undecene-7, dicyandiamide, tetramethylguanidine, or methylhexahydrophthalic acid anhydride, carboxylic acid hydrazide such as adipic acid hydrazide, carboxylic acid amide, monofunctional phenol or polyfunctional phenol compound such as bisphenol A, bis(4-hydroxyphenyl)sulfide, polyphenol compound, polymercaptan, carboxylic acid salt, and Lewis acid complex such as boron trifluoride ethylamine can be used, and among them, one or a mixture of two or more kinds of aromatic amine, sulfonic acid ester, monofunctional phenol, a polyfunctional phenol compound such as bisphenol A, or a polyphenol compound is preferable.

The liquid crystal polymer composition may contain, if necessary, a curing catalyst for the purpose of improving the curability. Examples thereof include an organic phosphine compound such as triphenylphosphine, tri-4-methylphenylphosphine, tri-4-methoxyphenylphosphine, tributylphosphine, trioctylphosphine, or tri-2-cyanoethylphosphine, and a triphenylborane complex thereof; quaternary phosphonium salt such as tetraphenylphosphonium tetraphenylborate or tetrabutylphosphonium tetraphenylborate; tertiary amine such as tributylamine, triethylamine, 1,8-diazabicyclo(5,4,0)undecene-7, or triamylamine; quaternary ammonium salt such as benzyltrimethylammonium chloride, benzyltrimethylammonium hydroxide, or triethylammonium tetraphenylborate; imidazoles such as 2-ethylimidazole or 2-ethyl-4-methylimidazole; and the like.

For the purpose of obtaining dispersion of a liquid crystal polymer without any heterogeneity in the liquid crystal polymer composition and semi-cured thermally conductive film and obtaining a thin film with even film thickness that is formed by removing a solvent from a cast product of the liquid crystal polymer composition, it is preferable that (III) the liquid crystal polymer is dissolved in (V) the solvent, or, when it is not dissolved in (V) the solvent, a fine powder. In the case of a fine powder, the polymer of which the average particle diameter and the maximum particle diameter are 50 μm or less and 200 μm or less, respectively, is preferable, the polymer of which the average particle diameter and the maximum particle diameter are 40 μm or less and 160 μm or less, respectively, is more preferable, the polymer of which the average particle diameter and the maximum particle diameter are 35 μm or less and 120 μm or less, respectively, is even more preferable, and the polymer of which the average particle diameter and the maximum particle diameter are 30 μm or less and 100 μm or less, respectively, is most preferable. A fine powder of the liquid crystal polymer is obtained by dry/wet mechanical pulverization, freeze pulverization in which the liquid crystal polymer is mechanically pulverized while it is cooled with liquid nitrogen, and chemical pulverization in which the liquid crystal polymer is dissolved at high temperature or dissolved in other compound/resin including a solvent or an epoxy compound followed by precipitation at room temperature to obtain a fine powder.

Upon heating of (III) the liquid crystal polymer, transition from a glass phase or crystal phase (hereinbelow, collectively referred to as a solid phase) to a liquid crystal phase occurs. Depending on the molecular structure of a liquid crystal polymer, transition from a liquid crystal phase to an isotropic phase occurs according to additional heating. In a liquid crystal phase or an isotropic phase, the liquid crystal polymer is fluid and allows molding processing. Those phase transition temperatures can be determined as a peak top of an endothermic peak during temperature raising process of a differential scanning calorimetry (DSC) measurement. The temperature at which (III) the liquid crystal polymer forms a liquid crystal phase, that is, the temperature for transition from a solid phase to a liquid crystal phase [in general, it indicates a transition point ($T_s$) from a solid phase to a liquid crystal phase] is 190°C or lower, preferably 180°C or lower, more preferably 170°C or lower, and even more preferably 160°C or lower. When it is higher than 190°C, sufficient composition fluidity is not obtained if the thermal curing is carried out using a facility like universal heat press machine or the like which has the upper limit temperature of 200°C, and, as the followability to a coarse surface of an adherend (conductive foil or the like) is poor, bondability or a favorable surface property is not obtained. It is preferable that the main chain structure of the liquid crystal polymer is composed of:

40 to 60% by mol of a unit (a) having a biphenyl group represented by General Formula (1)

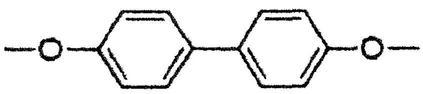

(1)

,

5 to 40% by mol of a unit (b) represented by General Formula (2)

$$-CO-R_1-CO- \qquad (2)$$

(wherein $R_1$ represents a linear divalent substituent group which has main chain atom number of 2 to 18 and may contain a branch), and

5 to 40% by mol of a unit (c) represented by General Formula (3)

$$-CO-R_2-CO- \qquad (3)$$

(wherein $R_2$ represents a linear divalent substituent group which has main chain atom number of 4 to 20 and may contain a branch, in which the main chain atom number is higher than that of $R_1$)

(with the provision that total of the units (a), (b), and (c) is 100% by mol).

$R_1$ in General Formula (2) indicates a linear divalent substituent group which has main chain atom number of 2 to 18 and may contain a branch.

$$-CO-R_1-CO- \qquad (2)$$

Herein, the main chain atom number indicates number of the atoms of a main chain skeleton (namely, number of atoms in the shortest covalent bonding chain which connects two bonding arms included in a linear divalent substituent

group, and ditto for the followings), and when $-R_1-$ is $-(CH_2)_8-$, for example, the main chain atom number is 8 in terms of the number of carbon atoms. From the viewpoint of having higher thermal conductivity, it is preferably a linear substituent group not containing a branch, and also preferably a linear aliphatic hydrocarbon chain not containing a branch. Furthermore, although $R_1$ may be either saturated or unsaturated, it is preferably a saturated aliphatic hydrocarbon chain. When an unsaturated bond is contained, there is a case in which a decrease in thermal conductivity is caused as sufficient bending property is not obtained. $R_1$ is preferably a saturated linear aliphatic hydrocarbon chain with carbon atom number of 2 to 18, more preferably a saturated linear aliphatic hydrocarbon chain with carbon atom number of 4 to 16, and most preferably a saturated linear aliphatic hydrocarbon chain with carbon atom number of 8 to 14. The main chain atom number of $R_1$ is preferably an even number. When it is an odd number, microscopic molecular orientation is impaired, and thus there is a case in which thermal conductivity is impaired. From the viewpoint of obtaining a resin with excellent heat resistance and thermal conductive property, in particular, $R_1$ is preferably one selected from $-(CH_2)_8-$, $-(CH_2)_{10}-$, and $-(CH_2)_{12}-$.

$R_2$ in General Formula (3) indicates a linear divalent substituent group which has main chain atom number of 4 to 20 and may contain a branch, in which the main chain atom number is higher than that of $R_1$.

$$-CO-R_2-CO- \qquad (3)$$

From the viewpoint of having higher thermal conductivity, it is preferably a linear substituent group not containing a branch, and also preferably a linear aliphatic hydrocarbon chain not containing a branch. Furthermore, although $R_2$ may be either saturated or unsaturated, it is preferably a saturated aliphatic hydrocarbon chain. When an unsaturated bond is contained, there is a case in which a decrease in thermal conductivity is caused as sufficient bending property is not obtained. $R_2$ is preferably a saturated linear aliphatic hydrocarbon chain with carbon atom number of 4 to 20, more preferably a saturated linear aliphatic hydrocarbon chain with carbon atom number of 8 to 18, and most preferably a saturated linear aliphatic hydrocarbon chain with carbon atom number of 10 to 18. The main chain atom number of $R_1$ is preferably an even number. When it is an odd number, microscopic molecular orientation is impaired, and thus there is a case in which thermal conductivity is impaired. As the difference in main chain atom number increases between $R_1$ and $R_2$, the crystallinity is impaired and the transition temperature from a solid phase to a liquid crystal phase decreases to 190°C or lower, and thus preferable. Furthermore, the processability for having thin-wall molding and flexibility of a molded article thereof increases. From the viewpoint of obtaining a resin with excellent flexibility due to decreased crystallinity, in particular, the main chain atom numbers m and n of the part corresponding to $R_1$ and $R_2$ preferably satisfy the following General Formula (7).

$$n - m \geq 4 \quad (7)$$

From the viewpoint of the chemical stability and obtainability, as a specific example of $R_2$ satisfying General Formula (7), one selected from $-(CH_2)_{10}-$, $-(CH_2)_{12}-$, and $-(CH_2)_{18}-$ is preferable.

The molar ratio (b)/(c) between the unit (b) and the unit (c), which copolymerize in the liquid crystal polymer, is preferably 8/1 to 1/8, more preferably 6/1 to 1/4, even more preferably 4/1 to 1/2, and most preferably 3/1 to 1/1. When the molar ratio of one unit is extremely higher or lower than 8/1 or 1/8, there may be a case in which the temperature for forming a liquid crystal phase is higher than 190°C, or a case in which, as the resin crystallinity increases to yield brittleness, it becomes difficult to have bonding strength of a thermally conductive film. Furthermore, having higher copolymerization ratio of the unit (b) with less main chain atom number than unit (c) is preferable in that, as the transition temperature of the liquid crystal polymer to an anisotropic phase increases, heat resistance of a resin can be enhanced.

The liquid crystal polymer preferably exhibits a smectic liquid crystal phase upon heating. As a representative type of liquid crystals, there are nematic liquid crystals and smectic liquid crystals. In the nematic liquid crystals, constitutional molecules have an oriented order, but no three-dimensional positional order. On the other hand, the smectic liquid crystal has a layer structure in which the aligned orientation of molecules is approximately parallel to the molecular axis, and the center of an area that is additionally aligned is present on the same plane. It is known that the smectic liquid crystals show, according to microscope observation under orthogonally polarized light, a unique pattern including a short bar-shaped (batonets) texture, a mosaic texture, a fan-shaped texture or the like.

The magnitude of crystallinity of a liquid crystal polymer can be determined by phase transition enthalpy ($\Delta H$) of an endothermic peak from a solid phase to a liquid crystal phase in the temperature increasing process of a DSC measurement. The higher $\Delta H$, the higher the degree of crystallinity is. In spite of a decreased degree of crystallinity due to a decreased orderliness of the molecular structure as the units (b) and (c) having different main chain atom number are copolymerized in the liquid crystal polymer, thermal conductivity of the resin itself is high, and thus a dramatically increased thermal conductivity is yielded when a thermal conductive filler is blended. It is considered to be possible as

a decrease in the degree of liquid crystallinity is minor even after the copolymerization, a micron-order anisotropic domain in which molecular chains are oriented can be formed, and this domain functions as a favorable thermal conductive path among inorganic fillers.

The terminal structure of the liquid crystal polymer is not particularly limited. However, the polymer chain terminal can be blocked with a monofunctional low molecular weight compound to increase the hydrolysis resistance and heat resistance for a long period of time. Furthermore, as the reaction with coexisting (I) the epoxy compound is suppressed, the liquid crystal polymer can easily form an orderly oriented structure in a cured product, and therefore desirable. At that time, the blocking ratio for entire molecular chain terminals is not less than 60%, preferably not less than 70%, more preferably not less than 80%, and most preferably not less than 90%.

The blocking ratio of the liquid crystal polymer terminal can be determined by measuring each of the number of blocked terminal functional group and the number of un-blocked terminal functional group of the resin, and using the following Equation (8). In terms of accuracy and convenience, the number of each terminal group is preferably determined, through $^1$H-NMR, based on an integral value of a characteristic signal corresponding to each terminal group. Terminal blocking ratio (%) = [Number of blocked terminal functional groups]/([Number of blocked terminal functional groups] + [Number of un-blocked terminal functional groups]) (8).

From the viewpoint of increasing the thermal conductivity of a liquid crystal polymer, the terminal blocking agent is preferably a monoamine or aliphatic monocarboxylic acid having 1 to 20 carbon atoms, more preferably an aliphatic monocarboxylic acid having 1 to 20 carbon atoms, and even more preferably an aliphatic monocarboxylic acid having 10 to 20 carbon atoms. Specific examples of the aliphatic monocarboxylic acid include aliphatic monocarboxylic acids such as acetic acid, propionic acid, butyric acid, valeric acid, caproic acid, caprylic acid, lauric acid, tridecanoic acid, myristic acid, palmitic acid, stearic acid, pivalic acid, and isobutyric acid; and any mixture of them. Among them, myristic acid, palmitic acid, and stearic acid are more preferable from the viewpoint of increasing especially the thermal conductivity of the resin. Specific examples of the monoamine include aliphatic monoamines such as methylamine, ethylamine, propylamine, butylamine, hexylamine, octylamine, decylamine, stearylamine, dimethylamine, diethylamine, dipropylamine, and dibutylamine; and any mixture of them. Among them, butylamine, hexylamine, octylamine, decylamine, stearylamine, and cyclohexylamine are more preferable from the viewpoint of reactivity, a high boiling point, stability of a blocked terminal, cost, and the like. The liquid crystal polymer can be copolymerized with another monomer to the extent that exhibition of the effect is not lost. Examples of the another monomer include aromatic hydroxycarboxylic acid, aromatic dicarboxylic acid, aromatic diol, aromatic hydroxylamine, aromatic diamine, aromatic aminocarboxylic acid or caprolactams, caprolactones, aliphatic dicarboxylic acid, aliphatic diol, aliphatic diamine, alicyclic dicarboxylic acid, alicyclic diol, aromatic mercaptocarboxylic acid, aromatic dithiol, and aromatic mercaptophenol.

Specific examples of the aromatic hydroxycarboxylic acid include 4-hydroxybenzoic acid, 3-hydroxybenzoic acid, 2-hydroxybenzoic acid, 2-hydroxy-6-naphthoic acid, 2-hydroxy-5-naphthoic acid, 2-hydroxy-7-naphthoic acid, 2-hydroxy-3-naphthoic acid, 4'-hydroxyphenyl-4-benzoic acid, 3'-hydroxyphenyl-4-benzoic acid, and 4'-hydroxyphenyl-3-benzoic acid, and an alkyl, an alkoxy, or a halogen substitution product of them.

Specific examples of the aromatic dicarboxylic acid include terephthalic acid, isophthalic acid, 2,6-naphthalenedicarboxylic acid, 1,6-naphthalenedicarboxylic acid, 2,7-naphthalenedicarboxylic acid, 4,4'-dicarboxybiphenyl, 3,4'-dicarboxybiphenyl, 4,4''-dicarboxyterphenyl, bis(4-carboxyphenyl)ether, bis(4-carboxyphenoxy)butane, bis(4-carboxyphenyl)ethane, bis(3-carboxyphenyl)ether, and bis(3-carboxyphenyl)ethane, and an alkyl, an alkoxy, or a halogen substitution product of them.

Specific examples of the aromatic diol include, for example, pyrocatechol, hydroquinone, resorcin, 2,6-dihydroxynaphthalene, 2,7-dihydroxynaphthalene, 1,6-dihydroxynaphthalene, 3,3'-dihydroxybiphenyl, 3,4'-dihydroxybiphenyl, 4,4'-dihydroxybiphenyl, 4,4'-dihydroxybiphenol ether, bis(4-hydroxyphenyl)ethane, and 2,2'-dihydroxybinaphthyl, and an alkyl, an alkoxy, or a halogen substitution product of them. Specific examples of the aromatic hydroxylamine include 4-aminophenol, N-methyl-4-aminophenol, 3-aminophenol, 3-methyl-4-aminophenol, 4-amino-1-naphthol, 4-amino-4'-hydroxybiphenyl, 4-amino-4'-hydroxybiphenyl ether, 4-amino-4'-hydroxybiphenylmethane, 4-amino-4'-hydroxybiphenylsulfide and 2,2'-diaminobinaphthyl, and an alkyl, an alkoxy, or a halogen substitution product of them.

Specific examples of the aromatic diamine and the aromatic aminocarboxylic acid include 1,4-phenylenediamine, 1,3-phenylenediamine, N-methyl-1,4-phenylenediamine, N,N'-dimethyl-1,4-phenylenediamine, 4,4'-diaminophenyl sulfide (thiodianiline), 4,4'-diaminobiphenyl sulfon, 2,5-diaminotoluene, 4,4'-ethylenedianiline, 4,4'-diaminobiphenoxyethane, 4,4'-diaminobiphenyl methane (methylenedianiline), 4,4'-diaminobiphenyl ether (oxydianiline), 4-aminobenzoic acid, 3-aminobenzoic acid, 6-amino-2-naphthoic acid, and 7-amino-2-naphthoic acid, and an alkyl, an alkoxy, or a halogen substitution product of them.

Specific examples of the aliphatic dicarboxylic acid include oxalic acid, malonic acid, succinic acid, glutaric acid, adipic acid, pimelic acid, suberic acid, azelaic acid, sebacic acid, dodecane dioic acid, tetradecane dioic acid, fumaric acid, and maleic acid.

Specific examples of the aliphatic diamine include 1,2-ethylenediamine, 1,3-trimethylenediamine, 1,4-tetramethylenediamine, 1,6-hexamethylenediamine, 1,8-octanediamine, 1,9-nonanediamine, 1,10-decanediamine, and 1,12-dodecanediamine.

Specific examples of the alicyclic dicarboxylic acid, aliphatic diol, and alicyclic diol include linear or branched aliphatic diols such as hexahydroterephthalic acid, trans-1,4-cyclohexane diol, cis-1,4-cyclohexane diol, trans-1,4-cyclohexanedimethanol, cis-1,4-cyclohexanedimethanol, trans-1,3-cyclohexane diol, cis-1,2-cyclohexane diol, trans-1,3-cyclohexanedimethanol, ethylene glycol, propylene glycol, butylene glycol, 1,3-propane diol, 1,2-propane diol, 1,4-butane diol, 1,6-hexane diol, 1,8-octane diol, 1,10-decane diol, 1,12-dodecane diol, or neopentyl glycol, and reactive derivatives of them.

Specific examples of the aromatic mercaptocarboxylic acid, the aromatic dithiol, and the aromatic mercaptophenol include 4-mercaptobenzoic acid, 2-mercapto-6-naphthoic acid, 2-mercapto-7-naphthoic acid, benzene-1,4-dithiol, benzene-1,3-dithiol, 2,6-naphthalene-dithiol, 2,7-naphthalene-dithiol, 4-mercaptophenol, 3-mercaptophenol, 6-mercapto-2-hydroxynaphthalene, 7-mercapto-2-hydroxynaphthalene, and reactive derivatives of them.

The number average molecular weight of the liquid crystal polymer is a value measured at 80°C by GPC in which polystyrene is used as a standard, and a solution prepared by dissolving the resin in a mixed solvent in which p-chlorophenol and toluene are mixed in a volume ratio of 3 : 8 so as to have a concentration of 0.25% by weight solution is used. The number average molecular weight is preferably 3000 to 70000, more preferably 4000 to 60000, and even more preferably 5000 to 50000. When the number average molecular weight is less than 3000, thermal conductivity may be impaired even for the resin having the same primary structure. Furthermore, when the number average molecular weight is more than 70000, molding processability may be impaired. The liquid crystal polymer can be produced by any well-known method. For the sake of having simple structure control, a production method by reacting a compound having a reactive functional group at both terminals of a biphenyl group and a compound having a reactive functional group at both terminals of each of the linear substituent groups $R_1$ and $R_2$ is preferable. Examples of such a reactive functional group which can be used include well-known groups such as a hydroxyl group, a carboxyl group, and an ester group. A condition under which such groups are caused to react with each other is not particularly limited, either. For the sake of having simple synthesis, as for the combination of the compound having a reactive functional group at both terminals of a biphenyl group and the compound having a reactive functional group at both terminals of the linear substituent groups $R_1$ and $R_2$, a combination of a compound having a hydroxyl group at both terminals of a biphenyl group and a compound having a carboxyl group at both terminals of the linear substituent groups $R_1$ and $R_2$ is preferable.

As an example of a method for producing a resin consisting of the compound having a hydroxyl group at both terminals of a biphenyl group and the compound having a carboxyl group at both terminals of the linear substituent groups $R_1$ and $R_2$, a method in which the hydroxyl groups of the compounds are individually or collectively converted to a lower fatty acid esters using a lower fatty acid such as acetic anhydride and then subjected to lower fatty acid-eliminating polycondensation reaction with the compounds having a carboxyl group at both terminals of linear substituent groups $R_1$ and $R_2$ in a reaction vessel or in separate reaction vessels can be mentioned. The polycondensation reaction is carried out, in a state in which a solvent is substantially not present, at a temperature generally of 220°C to 330°C and preferably of 240°C to 310°C, under a normal pressure or under a reduced pressure for 0.5 hour to 5 hours, in the presence of inert gas like nitrogen. If the reaction temperature is lower than 220°C, progress of the reaction is slow, and when it is higher than 330°C, a side reaction such as decomposition may easily occur. In a case in which the reaction is carried out under the reduced pressure, it is preferable to gradually increase the degree of pressure reduction. When the pressure is rapidly reduced to high vacuum degree, there is a case in which the monomer having linear substituent groups $R_1$ and $R_2$ is volatilized so that the resin with desired composition or molecular weight is not obtained. The final degree of vacuum is preferably not more than 40 Torr, more preferably not more than 30 Torr, even more preferably not more than 20 Torr, and particularly preferably not more than 10 Torr. When the degree of vacuum is more than 40 Torr, the acid elimination does not sufficiently progress, and there is a case in which the polymerization time is extended. It is possible to adopt multi-stage reaction temperature, and depending on a case, while raising the temperature or after arriving at the highest temperature, the reaction product may be directly discharged and recovered in a molten state. The resin thus obtained can be used as it is, or can be used after an unreacted raw material is removed therefrom or after being subjected to solid phase polymerization in order to improve a physical property of the resin. In a case in which the solid phase polymerization is carried out, it is preferable that the resin thus obtained is mechanically pulverized into particles whose particle diameter is not more than 3 mm, preferably not more than 1 mm, and then processed, for 1 hour to 30 hours, at a temperature of 100°C to 350°C in an atmosphere of an inert gas such as nitrogen or under a reduced pressure while the resin remains in a solid phase state. A resin particle diameter of more than 3 mm leads to insufficient processing and causes a physical property problem, and therefore undesirable. It is preferable to select the processing temperature or temperature increasing rate for the solid phase polymerization such that fusion of the particles of the liquid crystal polymer is not caused.

Examples of an acid anhydride of lower fatty acid that is used to produce the liquid crystal polymer include an acid anhydride of a lower fatty acid having 2 to 5 carbon atom number such as acetic anhydride, propionic acid anhydride, monochloroacetic acid anhydride, dichloroacetic acid anhydride, trichloroacetic acid anhydride, monobromoacetic acid anhydride, dibromoacetic acid anhydride, tribromoacetic acid anhydride, monofluoroacetic acid anhydride, difluoroacetic

acid anhydride, trifluoroacetic acid anhydride, butyric anhydride, isobutyric acid anhydride, valeric acid anhydride, and pivalic acid anhydride. In particular, acetic anhydride, propionic acid anhydride, and trichloroacetic acid anhydride are preferably used. The use amount of the acid anhydride of lower fatty acid is 1.01 to 1.5 equivalents, and preferably of 1.02 to 1.2 equivalents relative to a sum of amounts of functional groups, such as a hydroxyl group, contained in the monomer to be used. In a case in which it is less than 1.01 equivalents, since the acid anhydride of lower fatty acid is volatilized, functional groups such as a hydroxyl group do not completely react with an anhydride of lower fatty acid, so that there is a case in which a resin having a low molecular weight is obtained. For the production of the liquid crystal polymer, a catalyst may be used. As for the catalyst, a catalyst that has been conventionally well known as a polyester polymerization catalyst can be used, and examples thereof include metal salt catalysts such as magnesium acetate, stannous acetate, tetrabutyl titanate, lead acetate, sodium acetate, potassium acetate, and antimony trioxide; and organic compound catalysts such as N,N-dimethylaminopyridine and N-methylimidazole. The addition amount of the catalyst is generally $0.1 \times 10^{-2}$ to $100 \times 10^{-2}$% by weight, preferably $0.5 \times 10^{-2}$ to $50 \times 10^{-2}$% by weight, and even more preferably $1 \times 10^{-2}$ to $10 \times 10^{-2}$% by weight relative to a total weight of the resin.

In the liquid crystal polymer composition,
the volume ratio among the above (I), (II), and (III) is preferably {(I) + (II)} : (III) = 10 : 90 to 90 : 10, more preferably 20 : 80 to 85 : 15, and even more preferably 30 : 70 to 80 : 20. Because the bonding property is mainly imparted by {(I) + (II)} as an epoxy resin and thermal conductivity is imparted mainly by the (III), when {(I) + (II)} as an epoxy resin is lower than 10 : 90, the bondability and heat resistance may be insufficient, and when (III) the liquid crystal polymer is lower than 90 : 10, the thermal conductivity may be insufficient.
(IV) the thermal conductive filler has thermal conductivity of 1 W/(m·K) or higher. Use amount of the thermal conductive filler is, in terms of the volume ratio between the resin {(I) + (II) + (III)} and (IV) the thermal conductive filler, preferably 95 : 5 to 15 : 85, more preferably 70 : 30 to 20 : 80, even more preferably 50 : 50 to 25 : 75, and most preferably 40 : 60 to 25 : 75. When the volume ratio between the resins and thermal conductive filler is 100 : 0 to 95 : 5, there is a case in which sufficient thermal conductivity is not obtained. When the volume ratio between the resins and thermal conductive filler is 15 : 85 to 0 : 100, there is a case in which lower bondability is yielded due to a difficulty of having molding.

A well-known filler can be widely used as the thermal conductive filler. As for the thermal conductive filler, one having, by itself, a thermal conductivity of preferably 1 W/(m·K) or higher, more preferably 10 W/(m·K) or higher, even more preferably 20 W/(m·K) or higher, particularly preferably 30 W/(m·K) or higher, and most preferably 50 W/(m·K) or higher is used. An upper limit of the thermal conductivity of the thermal conductive filler is not particularly limited, and higher thermal conductivity of the inorganic filler is more preferable. However, in general, a filler with thermal conductivity of generally not more than 3000 W/(m·K), and further not more than 2500 W/(m·K) is preferably used.

As for the shape of the thermal conductive fillers, those having various shapes can be applied. Examples of the various shapes include a particle, a fine particle, a nanoparticle, an agglomerated particle, a tube shape, a nanotube shape, a wire shape, a rod shape, a needle shape, a plate shape, an amorphous shape, a rugby ball shape, a hexahedron shape, a composite particle in which a large particle and a fine particle are composited with each other, and a liquid. Those inorganic fillers can be either natural or synthetic. In a case in which those inorganic fillers are natural, they are not particularly limited in terms of resource area or the like, and can be suitably selected. The inorganic filler can be used either singly or in combination of two or more types which differ from each other in shape, average particle diameter, type, surface treatment agent, or the like.

An average particle diameter of the thermal conductive filler is preferably in a range of 0.1 μm to 50 μm, more preferably in a range of 1 μm to 30 μm, particularly preferably in a range of 3 μm to 20 μm, and most preferably 3 μm to 10 μm. When it is less than 0.1 μm, there may be a case in which the thermal conductivity of the thermally conductive film is insufficient, and when it is more than 50 μm, there may be a case in which obtainment of a thin thermally conductive film is difficult. When it is an average particle diameter within the above range, two or more types of thermal conductive fillers may be mixed, and thermal conductive fillers having two or more different average particle diameters may be mixed. Especially, in filling a large amount of thermal conductive filler, mixing thermal conductive fillers having two or more different average particle diameters in a preferable ratio is preferable as the melt viscosity of a resin composition can be reduced.

In a case in which the cured product is used for an application in which an electrical insulation property is not particularly required, as for the thermal conductive filler, a metal compound and an electrically conductive carbon compound, and the like are suitably used. Among them, from the viewpoint of having excellent thermal conductivity, a thermal conductive filler including an electrically conductive carbon material such as graphite, carbon nanotube, or carbon fiber, an electrically conductive metal powder obtained by microparticulating various metals, an electrically conductive metal fiber obtained by processing various metals into a fiber form, various ferrites such as a soft magnetic ferrite, and metal oxide such as zinc oxide, can be suitably used.

In a case in which the cured product is used for an application in which an electrical insulation property is required, as the thermal conductive filler, a compound exhibiting an electrical insulation property is suitably used. The electrical insulation property specifically means a property having an electrical resistance of not less than 1 Ω·cm.

However, it is preferable to use a compound having an electrical resistivity of preferably not less than 10 Ω·cm, more preferably not less than $10^5$ Ω·cm, even more preferably not less than $10^{10}$ Ω·cm, and most preferably not less than $10^{13}$ Q·cm. An upper limit of the electrical resistivity is not particularly limited, but it is generally not more than $10^{18}$ Ω·cm.

Among the thermal conductive fillers, specific examples of the compounds exhibiting an electrical insulation property include metal oxides such as aluminum oxide, magnesium oxide, silicon oxide, beryllium oxide, copper oxide, and cuprous oxide, metal nitrides such as boron nitride, aluminum nitride, and silicon nitride, metal carbides such as silicon carbide, metal carbonates such as magnesium carbonate, insulating carbon materials such as diamond, and metal hydroxides such as aluminum hydroxide and magnesium hydroxide. They can be used either singly or in combination of two or more types thereof.

The thermal conductive filler may be one having been subjected to a surface treatment with various surface treatment agents such as a silane treatment agent, in order to attain better bondability at an interface between the resin and the thermal conductive filler to facilitate processability. Such a surface treatment agent is not particularly limited, and a conventionally well-known surface treatment agent such as a silane coupling agent and a titanate coupling agent can be used, for example. In particular, a silane coupling agent containing an epoxy group such as epoxy silane, a silane coupling agent containing an amino group such as aminosilane, and a polyoxyethylene silane, are preferable because these silane coupling agents are less likely to reduce a physical property of the resin. A method for the surface treatment of the thermal conductive filler is not particularly limited, and a general surface treatment method can be used.

In the liquid crystal polymer composition a well-known filler other than the thermal, conductive filler described above can be widely used depending on the purpose. Examples of the filler other than the thermal conductive filler include diatomite powder, basic magnesium silicate, calcined clay, micronized silica, quartz powder, crystalline silica, kaolin, talc, antimony trioxide, micronized mica, molybdenum disulfide, inorganic fiber such as rock wool, ceramic fiber, and asbestos, and a glass filler such as glass fiber, glass powder, glass cloth, and molten silica. Use of such a filler makes it possible to enhance a property such as a thermal conductivity, a mechanical strength, or abrasion resistance, which property is preferable for an application of the resin composition. Moreover, as needed, it is possible to blend, in combination, an organic filler such as paper, pulp, wood, a synthetic fiber like polyamide fiber, aramid fiber, and boron fiber, and resin powder like polyolefin powder.

By containing (V) the solvent, the liquid crystal polymer composition can be made suitable for various molding processes. It is also made suitable for forming a thin semi-cured thermally conductive film. As for the solvent, a commonly used solvent can be used as long as it can dissolve (I) the epoxy compound. Specific examples thereof which can be used include alcohol based, ether based, ketone based, amide based, aromatic hydrocarbon based, ester based, and nitrile based. For example, toluene, methyl isobutyl ketone, dimethylacetamide, dimethylformamide, dimethyl sulfoxide, N-methyl-2-pyrrolidone, γ-butyrolactone, sulfolane, cyclohexanone, and methyl ethyl ketone can be used. The solvent used may be used either singly or in combination of two or more kinds thereof.

The thickness-direction thermal conductivity of a semi-cured thermally conductive film or a cured product is preferably 1 W/(m·K) or higher, more preferably 2.0 W/(m·K) or higher, even more preferably 5.0 W/(m·K) or higher, particularly preferably 6.0 W/(m·K) or higher, and most preferably 8 W/(m·K) or higher. When the thermal conductivity is less than 1 W/(m·K), it is difficult to efficiently deliver the heat generated from an electronic compartment. The upper limit of the thermal conductivity is not particularly limited, and a higher thermal conductivity is more preferable. However, one generally having 100 W/(m·K) or less, or one having 80 W/(m·K) or less is used.

The liquid crystal polymer composition may contain any well-known resin such as a polyolefin resin, a bismaleimide resin, a polyimide resin, a polyether resin, a phenolic resin, a silicon resin, a polycarbonate resin, a polyamide resin, a polyester resin, a fluororesin, an acrylic resin, a melamine resin, a urea resin, or an urethane resin within a range in which exhibition of the effect is not lost. Specific examples of a preferable resin include polycarbonate, polyethylene terephthalate, polybutylene terephthalate, a liquid crystal polymer, nylon 6, and nylon 6,6. The liquid crystal polymer composition may be additionally added with, as an additive other than the resin and the filler described above, any other component such as a reinforcing agent, a thickener, a mold releasing agent, a coupling agent, a flame retardant, a flame resistant agent, a pigment, a coloring agent, and other auxiliary agents depending on the purpose, within a range in which the effect is not lost. The use amount of those additives is preferably in a range of 0 to 100 parts by weight in total relative to 100 parts by weight of the resin. Especially, the addition of a flame retardant is preferable for imparting flame retardancy to the resin composition. The flame retardancy of the resin composition needs to satisfy V-0 of the UL-94 standard, and it may be a prerequisite for the resin composition to be adopted in electric and electronic devices dealing with large currents.

The amount of the flame retardant used is more preferably 7 to 80 parts by weight, even more preferably 10 to 60 parts by weight, and still even more preferably 12 to 40 parts by weight, relative to 100 parts by weight of the resin {(1) + (II) + (III)}. As the flame retardant, various kinds of flame retardants are known, and examples thereof include various flame retardants described in, for example, "Techniques and applications of polymer flame retardation" (p. 149 to 221), published by CMC Publishing Co., Ltd., but it is not limited thereto. Among these flame retardants, phosphorus-based flame retardants, halogen-based flame retardants, and inorganic flame retardants can be preferably used.

The phosphorus-based flame retardants include, for example, phosphate ester, halogen-containing phosphate ester, condensed phosphate ester, polyphosphate, and red phosphorus. These phosphorus-based flame retardants may be used either singly or in combination of two or more types thereof. Specifically, the halogen-based flame retardants are brominated polystyrene, brominated polyphenylene ether, a brominated bisphenol-type epoxy-based polymer, a brominated styrene maleic anhydride polymer, a brominated epoxy resin, a brominated phenoxy resin, decabromodiphenyl ether, decabromobiphenyl, brominated polycarbonate, perchlorocyclopentadecane, or a brominated cross-linked aromatic polymer. Particularly preferable are brominated polystyrene and brominated polyphenylene ether. These halogen-based flame retardants may be used either singly or in combination of two or more types thereof. Furthermore, it is preferable that a halogen element content of these halogen-based flame retardants is 15% to 87%.

Specific examples of the inorganic flame retardants include aluminum hydroxide, antimony trioxide, antimony pentoxide, sodium antimonate, tin oxide, zinc oxide, iron oxide, magnesium hydroxide, calcium hydroxide, zinc borate, kaolin clay, and calcium carbonate. These inorganic compounds may have been treated with a silane coupler, a titanium coupler, or the like and they may be used either singly or in combination of two or more types thereof.

The semi-cured thermally conductive film can be obtained through the steps of filtering, using a filter or the like as required, a solution obtained by dissolving in a solvent only the solvent-soluble components in the liquid crystal polymer composition to remove fine impurities contained in the solution, adding other components that are hardly soluble in the solvent, and casting smoothly and evenly on a supporting substrate (heat dissipating board or conductive foil can be used) the obtained liquid crystal polymer composition by various means like roller coating, dip coating, spray coating, spinner coating, curtain coating, slot coating, and screen printing, and removing the solvent thereafter. The method for removing solvent is, although not particularly limited, preferably carried out by solvent evaporation. As for the method for evaporating the solvent, methods including heating, reducing pressure, aeration, or the like can be mentioned. However, among them, from the viewpoint of the production efficiency and handlability, it is preferable to have the evaporation by heating, and the evaporation by heating under aeration is more preferable. At that time, as for the heating conditions, it is preferable to carry out for 10 minutes to 2 hours at 60 to 200°C. Homogeneous presence of (III) the liquid crystal polymer as a crystal in a cured product is desirable in terms of enhancing the thermal conductivity, as it is linked to efficient forming of the thermal conducting path filling the gaps among (IV) the thermal conductive fillers. From this point of view, it is preferable that (III) the liquid crystal polymer is melt by heating in (I) the epoxy compound, (II) the curing agent, or in a mixture of the (I) and (II), or (V) the solvent, or a mixture combining them, and (III) is either dissolved or precipitated by cooling to prepare a fine dispersion followed by curing.

When a fine powder of a liquid crystal polymer is blended similar to (IV) the thermal conductive filler, to have more homogeneous dispersion in the entire semi-cured thermally conductive film, it is preferable that the semi-cured thermally conductive film is formed through a step of removing the solvent from a cast product of the liquid crystal polymer composition followed by heating at the temperature at which the fine powder of (III) the liquid crystal polymer is melt. Herein, the temperature at which (III) the liquid crystal polymer is melt indicates a temperature at which, when only the three resin components {(I) + (II) + (III)} are separately prepared at a blending ratio that is present in a thermally conductive film, an anisotropic optical texture is not observed under an optical polarization microscope in the presence of a hot stage. This temperature corresponds to a temperature at which the liquid crystal polymer itself undergoes a transition to an isotropic phase, or a temperature at which the liquid crystal polymer is dissolved in the epoxy resin {(I) + (II)}. When the semi-cured thermally conductive film is finally cured by heating without undergoing the above step, the epoxy resin is cured while the liquid crystal polymer remains in a fine powder state. Accordingly, the liquid crystal polymer cannot sufficiently achieve the heat transfer function among the thermal conductive filler particles, and thus there may be a case in which the thermal conductivity of a cured product cannot be improved. Furthermore, the semi-cured thermally conductive film is more preferably formed through the step of heating a film, from which the solvent is removed from a cast product of the liquid crystal polymer composition, at a temperature at which (III) the liquid crystal polymer is melt followed by rapid cooling after the melting to form an orderly structure of the liquid crystal polymer. By curing the epoxy resin thereafter at a temperature at which the orderly structure of the liquid crystal polymer is maintained, a cured product with high thermal conductivity is obtained. Meanwhile, for a case in which the thermal conductive filler is filled at 50% by volume or more in the semi-cured thermally conductive film, there is a case in which the cured product has high thermal conductivity due to the liquid crystal polymer even when heat curing is performed directly at a temperature at which (III) the liquid crystal polymer is melt. In this regard, it is believed that, as there is a local area in which the liquid crystal polymer concentration is higher than the epoxy resin, and the liquid crystal polymer follows the surface of a thermal conductive filler while the liquid crystal polymer still maintains the orderly aligned structure, the liquid crystal polymer functions as a thermal conductive path between the thermal conductive fillers. Thickness of the semi-cured thermally conductive film which is obtained as described above is, although not particularly limited, preferably 500 μm or less. When the thickness is more than 500 μm, the heat resistance of a thermally conductive film increases so that there may be a case in which the heat dissipating effect of a heat generating body is insufficient. For the purpose of having smaller heat resistance, the thickness is preferably 300 μm or less, more preferably 200 μm or less, and even more preferably 100 μm or less. Lower limit of the thickness is, although not particularly limited, generally 10 μm or

more, preferably 30 μm or more, and more preferably 50 μm or more if there is an objective of ensuring insulative breakdown strength of a cured product or the like. Because the liquid crystal polymer composition of the present invention has easy handlability, and the semi-cured thermally conductive film obtained by using the composition has low anisotropy and high thermal conductivity in thickness direction, it can be used not only for an electronic circuit board of this embodiment but also as a TIM material for electric · electronic devices.

Furthermore, the term "film" used in the specification includes those from a very thin film in sheet shape to a thick film, and it includes not only a sheet shape but also a container shape like bottle shape.

When the semi-cured thermally conductive film of the present invention is electrically insulative, the insulative breakdown strength is preferably not less than 10 kV/mm, more preferably not less than 15 kV/mm, and even more preferably not less than 20 kV/mm. It is most preferably not less than 25 kV/mm. When it is less than 10 kV/mm, there may be a case in which use in electric and electronic devices dealing with large currents is impossible.

The semi-cured thermally conductive film of the present invention may also be composited with other base material. In applications that require insulating properties, the base material includes insulating base materials such as Kraft paper, glass cloth, nonwoven glass fabric, aramid paper, and mica sheet. In applications that do not require insulating properties, non-insulating base materials such as carbon fiber-based nonwoven fabric and cloth can be used. The semi-cured thermally conductive film of the present invention has high thermal conductivity in the thickness direction. Furthermore, the resin composition constituting the thermally conductive film has low specific gravity and good molding processability as it does not require a large amount of thermal conductive filler for the purpose of achieving the high thermal conductivity. Such a semi-cured thermally conductive film can be suitably used in electric and electronic devices such as a light emitting diode (LED), a power generator, a motor, a transformer, a current transformer, a voltage regulator, a rectifier, an inverter, and a charger, especially as a thermally conductive insulating paper and further especially as an insulating layer provided to ensure insulation between a metal substrate and a conductive foil for forming a wiring pattern. Furthermore, an electronic circuit board configured as such has high heat dissipation performance and can therefore contribute to further miniaturization and sophistication of the electric and electronic devices.

• Second Embodiment (according to the invention)

Hereinbelow, the present invention is described in detail. Furthermore, in the present application, the expression "A to B" indicates "A or more and B or less".

The thermoplastic resin according to the present invention (hereinbelow, it may be also simply described as a "resin") is a thermoplastic resin which has, as a main chain structure:

40 to 60% by mol of a unit (i) having a biphenyl group represented by General Formula (4)

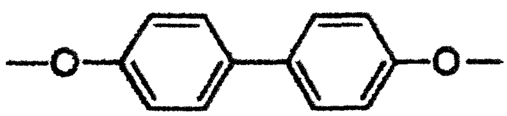

(4)

20 to 40% by mol of a unit (ii) represented by General Formula (5)

$$-CO-R_3-CO- \quad (5)$$

(wherein $R_3$ represents a linear divalent substituent group which has main chain atom number of 4 to 12 and may contain a branch), and 20 to 40% by mol of a unit (iii) represented by General Formula (6)

$$-CO-R_4-CO- \quad (6)$$

(wherein $R_4$ represents a linear divalent substituent group which has main chain atom number of 8 to 26 and may contain a branch, in which the main chain atom number is different from that of $R_3$)
(with the provision that total of the units (i), (ii), and (iii) is 100% by mol). The thermoplastic resin according to the present invention includes, as a main chain structure, the unit (i). Examples of a compound having the unit (i) include 4,4'-dihydroxybiphenyl.

The thermoplastic resin according to the present invention includes, as a main chain structure, the unit (ii). Examples of a compound having the unit (ii) include aliphatic dicarboxylic acid, and specific examples thereof include adipic acid, pimelic acid, suberic acid, azelaic acid, sebacic acid, undecane dioic acid, dodecane dioic acid, and tetradecane dioic acid.

With regard to the unit (ii) represented by General Formula (5) "-CO-$R_3$-CO-", which is included as a main chain structure in the resin of the present invention, $R_3$ in General Formula (5) indicates a linear divalent substituent group which has main chain atom number of 4 to 12 and may contain a branch.

Herein, the main chain atom number indicates number of the atoms of a main chain skeleton, and when "-$R_3$-" is "- $(CH_2)_8$-", for example, the main chain atom number is "8" as the number of carbon atoms. From the viewpoint of having lower thermal conductivity when a branch is included, $R_3$ is preferably a linear divalent substituent group not containing a branch, and also preferably a linear aliphatic hydrocarbon chain not containing a branch. Furthermore, although $R_3$ may be either saturated or unsaturated, it is preferably a saturated aliphatic hydrocarbon chain. When an unsaturated bond is contained in $R_3$, there is a case in which a decrease in thermal conductivity is caused as sufficient bending property is not obtained in a resin to be obtained. $R_3$ is preferably a saturated linear aliphatic hydrocarbon chain with carbon atom number of 4 to 12. Furthermore, the main chain atom number of $R_3$ is preferably an even number. When the main chain atom number of $R_3$ is an odd number, microscopic molecular orientation of a resin to be obtained is impaired, and thus there is a case in which thermal conductivity is impaired. From the viewpoint of obtaining a resin with low isotropic phase transition temperature and excellent thermal conductive property, $R_3$ is particularly preferably "-$(CH_2)_4$-", "-$(CH_2)_6$-", "-$(CH_2)_8$-", or "-$(CH_2)_{12}$-".

Ratio of the unit (ii) is 5 to 40% by mol, more preferably 20 to 40% by mol, and even more preferably 30 to 40% by mol when total of the units (i), (ii), and (iii) is 100% by mol. When the ratio of the unit (ii) is less than 5% by mol or more than 40% by mol, the transition point of the resin to a liquid crystal phase shifts toward a high temperature side, and thus the molding processing at low temperature is difficult to achieve.

The thermoplastic resin according to the present invention includes, as a main chain structure, the unit (iii). With regard to the unit (iii) represented by General Formula (6) "-CO-$R_4$-CO-", which is included as a main chain structure in the resin of the present invention, $R_4$ in General Formula (6) indicates a linear divalent substituent group which has main chain atom number of 8 to 26 that is different from the main chain atom number of $R_3$, and may contain a branch.

Herein, the main chain atom number indicates number of the atoms of a main chain skeleton, and when "-$R_4$-" is "- $(CH_2)_{18}$-", for example, the main chain atom number is "18" as the number of carbon atoms. From the viewpoint of having lower thermal conductivity when a branch is included, $R_4$ is preferably a linear divalent substituent group not containing a branch, and also preferably a linear aliphatic hydrocarbon chain not containing a branch. Furthermore, although $R_4$ may be either saturated or unsaturated, it is preferably a saturated aliphatic hydrocarbon chain. When an unsaturated bond is contained in $R_4$, there is a case in which a decrease in thermal conductivity is caused as sufficient bending property is not obtained in a resin to be obtained. $R_4$ is preferably a saturated linear aliphatic hydrocarbon chain with carbon atom number of 8 to 26, and particularly preferably a saturated linear aliphatic hydrocarbon chain with carbon atom number of 12 to 18. Furthermore, the main chain atom number of $R_4$ is preferably an even number. When the main chain atom number of $R_4$ is an odd number, microscopic molecular orientation of a resin to be obtained is impaired, and thus there is a case in which thermal conductivity is impaired. From the viewpoint of obtaining a resin with low isotropic phase transition temperature and excellent thermal conductive property, $R_4$ is particularly preferably "-$(CH_2)_{12}$-" or "-$(CH_2)_{18}$-".

Examples of a compound having the unit (iii) include aliphatic dicarboxylic acid, and specific examples thereof tetradodecane dioic acid and eicosane dioic acid.

Ratio of the unit (iii) is 5 to 40% by mol, more preferably 20 to 40% by mol, and even more preferably 30 to 40% by mol when total of the units (i), (ii), and (iii) is 100% by mol. When the ratio of the unit (ii) is less than 5% by mol or more than 40% by mol, the transition point of the resin to a liquid crystal phase shifts toward a high temperature side, and thus the molding processing at low temperature is difficult to achieve.

The molar ratio "(ii)/(iii)" between the unit (ii) and the unit (iii) that are copolymerized in the thermoplastic resin according to the present invention is preferably 8/1 to 1/8, preferably 2/1 to 1/2, and more preferably 4/3 to 3/4. When it is outside the range of 8/1 to 1/8, the resin crystallinity increases to yield brittleness, and thus it becomes difficult to have the flexibility of a molded article obtained by thin-wall molding. In particular, when the molar ratio is between 4/3 and 3/4, while the thermal conductivity is maintained, shift of the liquid crystal phase transition temperature of the resin toward a low temperature side reaches the maximum, and therefore desirable.

The molar ratio between the unit (i) and the units {(ii) + (iii)} in the thermoplastic resin of the present invention is generally 40 : 60 to 60 : 40, preferably 45 : 55 to 55 : 45, more preferably 48 : 52 to 52 : 48, and most preferably 50 : 50. As the molar ratio is close to 50 : 50, it becomes easier to increase the molecular weight during copolymerization, and therefore desirable.

The magnitude of crystallinity of a resin can be determined by phase transition enthalpy ($\Delta H$) of an endothermic peak from a solid phase to a liquid crystal phase in the temperature increasing process of a DSC measurement. The higher $\Delta H$, the higher the degree of crystallinity of a resin is. Because the unit (ii) is copolymerized with the unit (iii) having different main chain atom number in the resin of the present invention, in spite of a decreased degree of crystallinity due to a decreased orderliness of the molecular structure, thermal conductivity of the resin itself is high, and a dramatically

increased thermal conductivity is yielded when a thermally conductive inorganic filler is blended. It is considered to be possible, in the resin of the present invention, as a decrease in the degree of liquid crystallinity by the copolymerization is minor, a micron-order anisotropic domain in which molecular chains are oriented can be formed, and this domain functions as an excellent thermal conductive path among inorganic fillers.

The terminal structure of the thermoplastic resin according to the present invention is not particularly limited. However, for the purpose of increasing the compatibility with another resin or having a curable resin by using, as a curing agent, another compound with polyfunctional reactive group, the resin terminal can be prepared to be a carboxyl group. In that case, the ratio of the carboxyl group at entire terminals of a molecular chain is preferably 60% or more, more preferably 70% or more, even more preferably 80% or more, and most preferably 90% or more. Meanwhile, the resin terminal can be blocked with a monofunctional low molecular weight compound (terminal blocking agent) to increase the hydrolysis resistance and heat resistance for a long period of time of the resin. In that case, the blocking ratio for entire molecular chain terminals (terminal blocking ratio) is preferably 60% or more, more preferably 70% or more, even more preferably 80% or more, and most preferably 90% or more.

Herein, the terminal blocking ratio of the resin can be determined by measuring each of the number of blocked terminal functional group and the number of un-blocked terminal functional group of the resin, and using the following Equation (9)

Terminal blocking ratio (%) = [Number of blocked terminal functional groups]/([Number of blocked terminal functional groups] + [Number of un-blocked terminal functional groups]) (9).

In terms of accuracy and convenience, the number of each terminal functional group is preferably determined, by measuring $^1$H-NMR of the resin, based on an integral value of a characteristic signal corresponding to each terminal functional group.

From the viewpoint of increasing the thermal conductivity of the resin, the terminal blocking agent is preferably a monoamine or aliphatic monocarboxylic acid having 1 to 20 carbon atoms, more preferably an aliphatic monocarboxylic acid having 1 to 20 carbon atoms, and even more preferably an aliphatic monocarboxylic acid having 10 to 20 carbon atoms. Specific examples of the aliphatic monocarboxylic acid include acetic acid, propionic acid, butyric acid, valeric acid, caproic acid, caprylic acid, lauric acid, tridecanoic acid, myristic acid, palmitic acid, stearic acid, pivalic acid, and isobutyric acid; and any mixture of those monocarboxylic acids. Among those aliphatic monocarboxylic acids, myristic acid, palmitic acid, and stearic acid are more preferable from the viewpoint of increasing especially the thermal conductivity of the resin. Specific examples of the monoamine include aliphatic monoamines such as methylamine, ethylamine, propylamine, butylamine, hexylamine, octylamine, decylamine, stearylamine, dimethylamine, diethylamine, dipropylamine, dibutylamine, and cyclohexylamine; and any mixture of those aliphatic monoamines. Among those aliphatic monoamines, butylamine, hexylamine, octylamine, decylamine, stearylamine, and cyclohexylamine are more preferable from the viewpoint of reactivity, a high boiling point, stability of a blocked terminal, cost, and the like.

The thermal conductivity of the resin itself in the thermoplastic resin of the present invention is 0.3 W/(m·K) or higher, preferably 0.5 W/(m·K) or higher, more preferably 0.6 W/(m·K) or higher, even more preferably 0.7 W/(m·K) or higher, and most preferably 0.8 W/(m·K) or higher as a physical property value of an isotropic molded article. An upper limit of the thermal conductivity is not particularly limited, and a higher thermal conductivity is more preferable. In a case in which no physical treatment such as a magnetic field, voltage application, rubbing, or extension is carried out during the molding, the thermal conductivity of the resin is generally not more than 30 W/(m·K), and further not more than 10 W/(m·K).

As used herein, the thermal conductivity of a resin itself is a value of a thermal conductivity measured for the resin itself by use of a thermal conductivity measuring device. Alternatively, the thermal conductivity of a resin itself may be a value obtained by directly measuring a thermal conductivity of a resin composition containing an inorganic filler with an isotropic property in an amount of 30 to 40% by volume by using a device for measuring thermal conductivity, and then calculating a thermal conductivity of a resin matrix from Bruggeman's theoretical formula, that is, the following Equation (5):

$$1-V = \{(\lambda_c - \lambda_f)/(\lambda_m - \lambda_f)\} \times (\lambda_m/\lambda_c)^{1/3} \quad (10).$$

Herein, V is a volume content of the inorganic filler (0 < V < 1), $\lambda_c$ is a thermal conductivity of the resin composition, $\lambda_f$ is a thermal conductivity of the inorganic filler, and $\lambda_m$ is a thermal conductivity of the resin itself. Therefore, $\lambda_m$ can be calculated when V, $\lambda_c$, and $\lambda_f$ are known.

As an example of a method for determining whether or not a molded article is isotropic, the following method is considered. That is, a resin or a resin composition is molded into a square shape of 10 $\times$ 10 mm in thickness 200 to 300 $\mu$m, and each of thermal conductivities in the thickness direction and in the plane direction at room temperature (25°C) in the atmospheric pressure are measured separately by a laser flash method thermal conductivity measuring device (manufactured by NETZSCH; LFA447). In a case in which those thermal conductivities are nearly equal, a molded article is found to be isotropic.

It is also possible that thermoplastic resin according to the present invention is obtained by copolymerization of another monomer for introducing a structure other than the units (i), (ii), and (iii) to the main chain in which the copolymerization is made to the extent that the exhibited effect is not lost. Examples of the another monomer include aromatic hydroxycarboxylic acid, aromatic dicarboxylic acid, aromatic diol, aromatic hydroxylamine, aromatic diamine, aromatic aminocarboxylic acid, caprolactams, caprolactones, aliphatic dicarboxylic acid other than a compound having the unit (ii) or the unit (iii), aliphatic diol, aliphatic diamine, alicyclic dicarboxylic acid, alicyclic diol, aromatic mercaptocarboxylic acid, aromatic dithiol, and aromatic mercaptophenol.

Specific examples of the another aromatic hydroxycarboxylic acid include 3-hydroxybenzoic acid, 2-hydroxybenzoic acid, 2-hydroxy-5-naphthoic acid, 2-hydroxy-7-naphthoic acid, 2-hydroxy-3-naphthoic acid, 4'-hydroxyphenyl-4-benzoic acid, 3'-hydroxyphenyl-4-benzoic acid, and 4'-hydroxyphenyl-3-benzoic acid, and an alkyl, an alkoxy, or a halogen substitution product of those hydroxycarboxylic acids.

Specific examples of the another fat aromatic dicarboxylic acid include isophthalic acid, 1,6-naphthalenedicarboxylic acid, 2,7-naphthalenedicarboxylic acid, 4,4'-dicarboxybiphenyl, 3,4'-dicarboxybiphenyl, 4,4''-dicarboxyterphenyl, bis(4-carboxyphenyl)ether, bis(4-carboxyphenoxy)butane, bis(4-carboxyphenyl)ethane, bis(3-carboxyphenyl)ether, and bis(3-carboxyphenyl)ethane, and an alkyl, an alkoxy, or a halogen substitution product of those dicarboxylic acids.

Specific examples of the another aromatic diol include, for example, pyrocatechol, hydroquinone, resorcin, 2,6-dihydroxynaphthalene, 2,7-dihydroxynaphthalene, 1,6-dihydroxynaphthalene, 3,3'-dihydroxybiphenyl, 3,4'-dihydroxybiphenyl, 4,4'-dihydroxybiphenol ether, bis(4-hydroxyphenyl)ethane, 2,2'-dihydroxybinaphthyl, and an alkyl, an alkoxy, or a halogen substitution product of those diols. The curable resin of the (B) component is at least one type of a curable resin that is selected from an epoxy resin, an acrylic curable resin, a guanamine resin, a diallyl phthalate resin, a phenol resin, a maleic acid resin, a melamine resin, a urea resin, a furan resin, an alkyd resin, and an unsaturated polyester resin. From the viewpoint of the bonding strength, in particular, an epoxy resin is preferable.

The epoxy resin can be used without being limited to a solid or a liquid phase at room temperature. From the viewpoint of maintaining the bonding strength when the inorganic filler is increased, a naphthalene type epoxy resin is particularly preferable.

The liquid phase epoxy resin is not particularly limited as long as it is an epoxy resin in liquid phase at room temperature, and various epoxy resins can be used. Examples thereof include one or more kinds that are selected from bisphenol A type epoxy resin, bisphenol F type epoxy resin, biphenyl type epoxy resin, hydrogenated bisphenol A type epoxy resin, aliphatic type epoxy resin, stilbene type epoxy resin, orthocresol novolac type epoxy resin, phenol novolac type epoxy resin, modified phenol type epoxy resin, triphenolmethane type epoxy resin, alkyl modified triphenolmethane type epoxy resin, triazine nucleus-containing epoxy resin, naphthalene type epoxy resin, dicyclopentadiene type epoxy resin, dicyclopentadiene modified phenol type epoxy resin, and glycidyl amine type epoxy resin.

The solid epoxy resin is not particularly limited as long as it is an epoxy resin in solid phase at room temperature, and various epoxy resins can be used. Examples thereof include one or more kinds that are selected from bisphenol A type epoxy resin, bisphenol F type epoxy resin, orthocresol novolac type epoxy resin, phenol novolac type epoxy resin, modified phenol type epoxy resin, naphthalene type epoxy resin, triphenolmethane type epoxy resin, alkyl modified triphenolmethane type epoxy resin, triazine nucleus-containing epoxy resin, dicyclopentadiene type epoxy resin, glycidyl amine type epoxy resin, biphenyl type epoxy resin, biphenyl aralkyl type epoxy resin, hydrogenated bisphenol A type epoxy resin, aliphatic type epoxy resin, stilbene type epoxy resin, and bisphenol A novolac type epoxy resin.

The naphthalene type epoxy resin indicates an epoxy resin having a skeleton which includes at least one naphthalene ring in one molecule, and naphthol-based, naphthalene diol-based or the like can be mentioned. Examples of the naphthalene type epoxy resin include a naphthalene type epoxy resin such as 1,3-diglycidyl ether naphthalene, 1,4-diglycidyl ether naphthalene, 1,5-diglycidyl ether naphthalene, 1,6-diglycidyl ether naphthalene, 2,6-diglycidyl ether naphthalene, 2,7-diglycidyl ether naphthalene, 1,3-diglycidyl ester naphthalene, 1,4-diglycidyl ester naphthalene, 1,5-diglycidyl ester naphthalene, 1,6-diglycidyl ester naphthalene, 2,6-diglycidyl ester naphthalene, 2,7-diglycidyl ester naphthalene, 1,3-tetraglycidylaminenaphthalene, 1,4-tetraglycidylaminenaphthalene, 1,5-tetraglycidylaminenaphthalene, 1,6-tetraglycidylaminenaphthalene, 1,8-tetraglycidylaminenaphthalene, 2,6-tetraglycidylaminenaphthalene, or 2,7-tetraglycidylaminenaphthalene. It is preferable that the naphthalene type epoxy resin is included in the component (B), and it may be used either singly or in combination of two or more types thereof. Furthermore, the naphthalene type

epoxy resin also has excellent heat resistance, and also due to this reason, it is suitable for highly-thermal conductive use.

As a curing agent of the component (C), a well-known curing agent that is generally used can be used. Examples thereof include an amine compound, a polyamide amine compound, a cyanate ester compound, a phenol resin, acid anhydride, carboxylic acid, dicyandiamide, organic acid dihydrazide, a tertiary amine compound, imidazole, a Lewis acid, a Broensted acid salt, a polymercaptan-based curing agent, a urea resin, a melamine resin, an isocyanate compound, a block isocyanate compound, and a latent curing agent. The curing agent may be used either singly or in combination of two or more types thereof.

As for the imidazole curing agent, 2-methylimidazole, 2-undecylimidazole, 2-heptadecylimidazole, 2-ethyl-4-methylimidazole, 2-phenylimidazole, 2-phenyl-4-methylimidazole, 2,4-diamino-6-[2'-methylimidazolyl-(1')]ethyl-s-triazine, 2-phenyl-4,5-dihydroxymethylimidazole, 2-phenyl-4-methyl-5-hydroxymethylimidazole, and 2,3-dihydro-1H-pyrrolo[1,2-a]benzimidazole, and 2,4-diamino-6-[2'-methylimidazolyl-(1')]ethyl-s-triazine, 2,4-diamino-6-[2'-undecylimidazolyl-(1)]-ethyl-s-trizaine, and 2,4-diamino-6-[2'-ethyl-4'-methylimidazolyl-(1')]-ethyl-s-triazine or the like are preferable from the viewpoint of curing rate, workability, and moisture resistance of the resin composition.

As for the latent curing agent, dicyandiamide, a dihydrazide compound like adipic acid dihydrazide, guanamine acid, melamine acid, an addition compound of an epoxy compound and an imidazole compound, an addition compound of an epoxy compound and dialkylamines, an addition compound of amine and urea, thiourea, or a derivative thereof (amine-ureido adduct latent curing promoter), and an addition compound of amine and isocyanate (amine-urethane adduct latent curing promoter) can be mentioned. The acrylic curable resin is a resin which has, at both terminals of the acrylic resin, reactive groups capable of having thermal curing, and examples thereof include KANEKA XMAP RC-100C manufactured by KANEKA CORPORATION.

The guanamine resin is a resin which contains, as a main component, a polymer obtained by an addition condensation reaction of guanamines and aldehydes, and it is generally exemplified by a resin consisting of benzoguanamine and formaldehyde. Examples of the guanamine resin further include a resin in which guanamine is co-reacted or co-condensed with urea, melamine, thiourea, or the like, and a resin in which guanamine is etherified with butanol, methanol, or the like.

The diallyl phthalate resin is a curable homopolymer or copolymer which contains diallyl phthalate as a main component. Examples of a monomer to be copolymerized include styrene, $\alpha$-methyl styrene, acrylic acid ester, and methacrylic acid ester.

The phenol resin is a resin which contains, as a main component, a polymer obtained from a condensation reaction of phenols and aldehydes, and those consisting of phenol, m-cresol, 3,5-xylenol, p-alkylphenol, resorcin, or the like, and formaldehyde are suitable. The phenol resin can be condensed by a condensation reaction catalyzed with a normal acid catalyst or a basic catalyst, and if necessary, a curing agent such as hexamethylene tetramine, or a filler such as wood flour, pulp, and an aggregating material can be used.

The melamine resin is a resin which contains, as a main component, a polymer obtained by an addition condensation reaction of melamine and aldehydes, and as the aldehydes, formaldehyde is generally used. Furthermore, the melamine resin encompasses a melamine resin which is co-condensed with urea or the like. The melamine resin is generally cured by heating. However, according to need, a curing agent can be used.

The area resin is a resin which contains, as a main component, a polymer obtained by a condensation reaction of urea and aldehydes. The aldehydes to be used are generally formaldehyde. The urea resin encompasses a urea resin which is co-condensed with thiourea, melamine, phenol, or the like. Cellulose or the like can be mixed in the aforementioned melamine resin and the urea resin according to need.

The furan resin is a resin which contains, as a main component, a polymer obtained solely from furfuryl alcohol, or obtained by a condensation reaction of furfuryl alcohol and formaldehyde. Examples of the furan resin include a furfuryl alcohol/furfural co-condensation resin, a furfuryl alcohol resin, a furfural/phenol co-condensation resin, a furfural/ketone co-condensation resin, a furfuryl alcohol/urea copolymer resin, and a furfuryl alcohol/phenol co-condensation resin.

The alkyd resin is a resin which contains, as a main component, a polymer obtained by a condensation reaction of polybasic acid and polyhydric alcohol. Generally, the polybasic acid to be used is phthalic anhydride, isophthalic acid, maleic acid, fatty oil, fatty acid, rosin, ester rosin, or the like, and the polyhydric alcohol to be used is generally glycerin.

In the present invention, not only one type of the above curable resin can be used but also two or more types thereof can be used in combination, depending on the circumstances. Moreover, it is also possible to use in combination a thermocurable resin such as unsaturated polyester or polyurethane.

Curing of the composition of the present invention can be carried out, in the presence or absence of a curing agent or a curing promoter, by a method like heating, no-heating, or ultraviolet ray irradiation. Furthermore, as another additives that are blended in the curable resin composition, electrically conductive particles, thermally conductive particles, a film forming resin, an acrylic rubber, a monomer for dilution like various acrylic monomers, a filler, a softening agent, a colorant, a flame retardant, a thixotropic agent, a coupling agent, or the like can be blended.

The elastomer as the component (D) is mainly used for enhancing the bonding strength. Furthermore, because

the component (D) has suitable flexibility such that the resin composition after curing can relieve the stress from outside, the stress which occurs inside a semiconductor instrument can be relieved by it. Examples of the component (D) include a styrene-butadiene block copolymer (SBS), a styrene-ethylene/butylene-styrene block copolymer (SEBS), a styrene-isoprene-styrene block copolymer (SIS), a styrene-isobutylene-styrene copolymer (SIBS), a styrene-isobutylene copolymer (SIB), a polybutadiene (PB), and a styrene-(ethylene-ethylene/propylene)-styrene block copolymer (SEEPS).

The component (D) may be used either singly or in combination of two or more types thereof. Use of any one from those can be suitably selected depending on the property to be imparted to an adhesive sheet. For example, a styrene-ethylene/butylene-styrene block copolymer is preferable from the viewpoint of imparting heat resistance to an adhesive sheet after curing, and a styrene-(ethylene-ethylene/propylene)-styrene block copolymer is preferable from the viewpoint of imparting bonding strength to an adhesive sheet. Due to such reasons, as the component (D), it is preferable to use in combination the styrene-ethylene/butylene-styrene block copolymer and styrene-(ethylene-ethylene/propylene)-styrene block copolymer.

As for the inorganic filler as the component (E), a common inorganic filler can be used.

As for the component (E), those having thermal conductivity of 5 W/m·K or higher are preferable. From the viewpoint of the insulating property and thermal expansion coefficient, at least one inorganic filler selected from a group consisting of MgO, $Al_2O_3$, AlN, BN, diamond filler, ZnO, SiC, and $SiO_2$ is preferable. From the viewpoint of the thermal conductivity, insulating property, and thermal expansion coefficient, at least one inorganic filler selected from a group consisting of MgO, $Al_2O_3$, AlN, BN, diamond, ZnO, and SiC is preferable. Furthermore, an insulating treatment may be carried out for ZnO and SiC, if necessary. Exemplary results of measuring the thermal conductivity of each material are as follows (unit: W/m·K) : MgO; 37, $Al_2O_3$; 30, AlN; 200, BN; 30, diamond; 2000, ZnO; 54, and SiC; 90. Furthermore, the exemplary result of measuring the thermal conductivity of $SiO_2$ is 1.4 (unit: W/m·K).

The average particle diameter of the component (E) (when it is not particulate, average maximum diameter thereof) is, although not particularly limited, preferably 0.05 to 50 μm from the viewpoint of having homogeneous dispersion of the component (E) in the curable resin composition. When it is less than 0.05 μm, there is a possibility of having poor moldability due to increased viscosity of the curable resin composition. On the other hand, when it is more than 50 μm, there may be a case in which thin-wall molding of an adhesive sheet formed of the curable resin composition is difficult to achieve.

From the viewpoint of the thermal conductivity and heat resistance of insulation after curing, the component (A) is preferably 10 to 70 parts by mass, more preferably 30 to 70 parts by mass, and even more preferably 40 to 70 parts by mass relative to 100 parts by mass of total of the component (A), the component (B), the component (C) and the component (D) (hereinbelow, it is referred to as "total of the components (A) to (D)"). When it is 10 parts by mass or less, thermal conductivity of the curable resin composition may become insufficient, and when it is 70 parts by mass or more, heat resistance may become insufficient.

The component (B) is preferably 0.5 to 30 parts by mass, more preferably 1.0 to 15 parts by mass, and even more preferably 5 to 15 parts by mass relative to 100 parts by mass of the total of the components (A) to (D). When the component (B) is less than 0.5 part by mass relative to 100 parts by mass of the total of the components (A) to (D), bonding strength and heat resistance may become insufficient, and when it is more than 30 parts by mass or more, cut resistance (bending property) of an adhesive sheet itself is lost, and thus it may become impossible to carry out an adhesive sheet molding.

Effective amount of the component (C) varies depending on type. When the component (C) is a phenol-based curing agent, an amine-based curing agent, or an acid anhydride-based curing agent, it is preferable that the active hydrogen equivalents are the same as the functional group equivalents of the component (B). When the component (B) is an epoxy resin and the component (C) is an imidazole curing agent, 0.1 to 5 parts by mass relative to 100 parts by mass of the total of the components (A) to (D) is more preferable. Even more preferably, it is 0.2 to 4 parts by mass. From the viewpoint of the bondability, a cured product of the imidazole-based is preferable.

From the viewpoint of the elasticity of a curable resin compound after curing and bonding strength of an adhesive sheet consisting of the curable resin composition, the component (D) is preferably 10 to 60 parts by mass, more preferably 15 to 50 parts by mass, and even more preferably 20 to 45 parts by mass relative to 100 parts by mass of the total of the components (A) to (D). When it is 10 parts by mass or less, poor bonding strength and poor elasticity may be yielded, and when it is 60 parts by mass or more, it may become difficult to have both the heat resistance and high thermal conductivity provided by the components (A) to (C).

From the viewpoint of the insulating property, bonding property, and thermal expansion coefficient, the component (E) is, in terms of the volume ratio between the resins (total of the components (A) to (D)) and the component (E), preferably 95 : 5 to 20 : 80, more preferably 90 : 10 to 20 : 80, even more preferably 80 : 20 to 20 : 80, and most preferably 40 : 60 to 20 : 80. With a resin composition in which the volume ratio between the resin and inorganic filler is 100 : 0 to 95 : 5, sufficient thermal conductivity may not be obtained. With a resin composition in which the volume ratio between the resin and inorganic filler is 20 : 80 to 0 : 100, it is easy to have lower bonding force of an adhesive sheet.

Furthermore, within a range in which the effect of the present invention is not impaired, the curable resin

composition may contain an additive like adhesiveness imparting agent, anti-foaming agent, fluidity regulating agent, film forming aid, and dispersion aid, or an organic solvent. Examples of the organic solvent include an aromatic solvent such as toluene or xylene and a ketone solvent such as methyl ethyl ketone, cyclohexanone, and methyl isobutyl ketone. Furthermore, a halogen based solvent like trichloroethane, dichloromethane, and chloroform can be also mentioned as a candidate. Examples of the solvent other than those include N-methyl-4-pyrrolidone, tetrahydrofuran, and 1,4-dioxane. The organic solvent may be used either singly or in combination of two or more types thereof. Furthermore, the use amount of the organic solvent is not particularly limited, but it is used such that the solid content is 20 to 50% by mass.

The curable resin composition can be obtained by dissolving or dispersing raw materials containing the components (A) to (E) in an organic solvent. A device for dissolving or dispersing the raw materials is not particularly limited, but a milling machine equipped with a stirring and heating device, a triple roll mill, a ball mill, a planetary mixer, a beads mill, or the like can be used. Furthermore, it is also possible to use those devices in suitable combination.

[Adhesive sheet]

The adhesive sheet of the present invention is formed with the curable resin composition described above.

The adhesive sheet can be obtained by applying the curable resin composition on a desired support followed by drying. The support is not particularly limited, and examples thereof include a metal foil such as copper or aluminum, and an organic film such as a polyester resin, a polyethylene resin, or a polyethylene terephthalate resin. It is also possible that the support has been subjected to a release treatment with a silicone compound or the like.

The method for applying the curable resin composition on a support is not particularly limited, but from the viewpoint of having a thin film and controlling film thickness, a microgravure method, a slot die method, and a doctor blade method are preferable. According to a doctor blade method, a 50 to 250 μm sheet after curing can be produced, for example.

Drying conditions can be suitably set depending on type or amount of an organic solvent used for the curable resin composition or application thickness or the like, and they can be for 1 to 45 minutes at 50 to 90°C, for example. The resin composition for an adhesive sheet obtained accordingly has favorable storage stability. Furthermore, it is possible to peel the adhesive sheet from a support at desired timing.

Homogeneous crystalline presence of the component (A) as a fine particle in the resin composition is desirable in that a thermal conductive path filling the gaps among inorganic fillers is effectively created and linked, and the thermal conductivity can be enhanced. In the case of a resin composition in which (E) inorganic filler is charged in a large amount, voids may remain after solvent drying. However, by applying heat press, voids can be removed as the component (A) is fluidized, and it leads to an enhancement of the thermal conductivity and mechanical strength. From these points of view, it is desired that the adhesive sheet resin composition is subjected to, after drying, heat press at a temperature that is not lower than the solid phase-to-liquid crystal phase transition point of the component (A) in the resin composition so as to have homogeneous dispersion of the component (A) in the resin composition. When it is the same or higher than the melting temperature of the component (A) in the resin composition, in particular, sufficient fluidity can be obtained. In that case, it is required to have rapid cooling after heat press. It is desirable to have the press for 30 seconds to 2 minutes at press temperature of 100 to 270°C. When the press temperature is excessively high, thermal curing progresses if the component (B) is a thermocurable resin, and thus the fluidity required for forming crystals after melting of the component (A) cannot be obtained and the crystallization is interfered, yielding a case in which the thermal conductivity is not exhibited. From the above point of view, the press temperature is more preferably 150°C to 220°C, for 2 minutes or shorter. It is even more preferably 160°C to 220°C, for 1 minute and 30 seconds or shorter. It is also acceptable that the component (A) is melt in a mixture of (B) the curable resin, or (D) the elastomer, a mixture of (B) and (D), or a solvent, or a mixture in which they are combined, and, when an alloy in which the component (A) is finely dispersed is prepared in advance, applied with heat press at a temperature that is not higher than the melting temperature.

The resin composition after press can be thermally cured for 30 to 180 minutes at 130 to 220°C.

Thickness of the adhesive sheet is preferably 10 μm or more and 300 μm or less, more preferably 10 μm or more and 100 μm or less, and even more preferably 10 μm or more and 150 μm or less. When it is less than 10 μm, there may be a possibility that desired insulating property or sufficient mechanical strength is not obtained. When it is more than 300 μm, there may be a possibility that the heat dissipating property of a semiconductor is insufficient.

EXAMPLES

Next, the resin composition of the present invention is described in more detail with reference to Production Examples, Examples, and Comparative Examples, but the present invention is not limited only to the Examples. Furthermore, with regard to each reagent described below, reagents manufactured by Wako Pure Chemical Industries, Ltd. were used with no purification if not otherwise specified.

• First Embodiment (reference)

[Evaluation method]

Number average molecular weight: A sample was prepared by dissolving the resin used herein in a mixed solvent that contains p-chlorophenol (manufactured by Tokyo Chemical Industry Co., Ltd.) and toluene in a volume ratio of 3 : 8 so that the sample has a concentration of 0.25% by weight. Polystyrene was used as a standard material for preparing a similar sample solution. The measurement was carried out by high-temperature GPC (manufactured by Viscotek; 350 HT-GPC System) under conditions in which a column temperature was 80°C, and a flow rate was 1.00 mL/min. A differential refractometer (RI) was used as a detector. Evaluation of phase transition temperature resin crystallinity and liquid crystallinity: According to differential scanning calorimetry measurement (DSC measurement), temperature increase/decrease is carried out at 10°C/min in a range of 50°C to 300°C once, and from the peak top of an endothermic peak at the second temperature increase at 10°C/min, solid phase-to-liquid crystal phase transition point ($T_s$) and liquid crystal phase-to-isotropic phase transition point ($T_i$) were obtained.

Thermal conductivity: A semi-cured thermally conductive film inserted in highly heat-resistant release film made of aluminum, or a resin-adhered copper foil in which a highly heat-resistant release film made of aluminum is laminated to have a contact with the resin is subjected to heat press at conditions including 180°C, 2 h, 4 MPa to produce a cured product with thickness of 0.2 mm. After removing the release film, the sample with adhered copper was subjected to an etching treatment to remove the copper. After cutting to an angle of 10 mm, thermal diffusivity in thickness direction in room temperature atmosphere was measured by using a device for measuring a laser flash thermal diffusivity (manufactured by NETZSCH; LFA447). Specific heat was measured by using a differential scanning calorimeter (DSC) and comparing with a sapphire standard material. Density was measured according to Archimedes' principle, and thermal conductivity was calculated from the equation: thermal conductivity = thermal diffusivity × specific heat × density.
90° Peel strength: Copper foil of each electronic circuit board was subjected to an etching processing to form patterns with width of 1 mm, and the strength at the time of peeling the copper foil pattern in perpendicular direction at speed of 50 mm/minute was measured.

Solder heat resistance: Each electronic circuit board with an angle of 30 mm was added on top of a soldering bath at 280°C and allowed to stand for 3 minutes. After that, presence of any defective appearance like swelling or peeling of copper foil or the like was determined with a naked eye.

[Materials that are used]

<(I) Epoxy compound>

(I-1) Bisphenol A type epoxy resin jER828 (manufactured by Mitsubishi Chemical Corporation)
(1-2) Biphenyl skeleton type epoxy resin YX4000 (manufactured by Mitsubishi Chemical Corporation)
(1-3) Naphthalene type epoxy resin EPICLON HP-4032D (manufactured by DIC Corporation)
(1-4) Bisphenol A type epoxy resin jER1010 (manufactured by Mitsubishi Chemical Corporation)

<(II) Curing agent>

(II-1) Diaminodiphenylsulfon, Seikacure-S (manufactured by Wakayama Seika Kogyo Co., Ltd.)
(II-2) 2-Ethyl-4-methylimidazole (manufactured by SHIKOKU CHEMICALS CORPORATION)
(II-3) Phenol novolac, H-4 (manufactured by Meiwa Plastic Industries, Ltd.)

<Liquid crystal polymer (III)>

[Production Example 1]

Into a sealing type reaction vessel equipped with a reflux condenser, a thermometer, a nitrogen introduction tube, and a stirring bar, 4,4'-dihydroxybiphenyl, sebacic acid, and tetradecane dioic acid were added in a ratio of 50 : 37.5 : 12.5% by mol, respectively, and then 2.1 equivalents of acetic anhydride relative to 4,4'-dihydroxybiphenyl and a catalytic amount of sodium acetate were added. According to the reaction under normal pressure in an atmosphere of nitrogen at 145°C, a homogeneous solution was obtained, and thereafter, the temperature was raised to 260°C at

2°C/min while acetic acid was removed by distillation followed by stirring at 260°C for 1 hour. Subsequently, the pressure was reduced to 10 Torr over approximately 60 minutes while maintaining the same temperature, and then the reduced pressure was maintained. 1.5 Hours after the start of the pressure reduction, the pressure was brought back to normal pressure by use of a nitrogen gas, and then a polymer thus generated was taken out. The number average molecular weight was 12,000, $T_s$ was 121°C, and $T_i$ was 251°C. The obtained liquid crystal polymer was cooled with liquid nitrogen followed by freeze drying, and by controlling the pulverization time, fine powder having average particle diameter of 24 μm, and the maximum particle diameter of 98 μm was obtained. It was referred to as (III-1). By also controlling the pulverization time, fine powder having average particle diameter of 52 μm, and the maximum particle diameter of 209 μm was obtained. It was referred to as (III-2).

[Production Example 2]

A resin was obtained in the same manner as Production Example 1 except that 4,4'-dihydroxybiphenyl, tetradecane dioic acid, and eicosane dioic acid were added as a raw material in a ratio of 50 : 25 : 25% by mol, respectively. The resin thus obtained showed a number average molecular weight of 12,000, and the resin itself has a thermal conductivity $T_s$ of 110°C, and $T_i$ of 201°C. The liquid crystal polymer thus obtained was dissolved in N-methylpyrrolidone at 170°C, and according to cooling to room temperature for chemical pulverization followed by filtration and washing with methanol, fine powder having average particle diameter of 43 μm, and the maximum particle diameter of 192 μm was obtained. It was referred to as (III-3).

[Production Example 3]

Into a sealing type reaction vessel equipped with a reflux condenser, a thermometer, a nitrogen introduction tube, and a stirring bar, 4,4'-dihydroxybiphenyl and dodecane dioic acid were added in a ratio of 50 : 50% by mol, respectively, and then 2.1 equivalents of acetic anhydride relative to 4,4'-dihydroxybiphenyl and a catalytic amount of 1-methylimidazole were added. According to the reaction under normal pressure in an atmosphere of nitrogen at 145°C, a homogeneous solution was obtained, and thereafter, the temperature was raised to 270°C at 2°C/min while acetic acid was removed by distillation followed by stirring at 270°C for 1 hour. Subsequently, the pressure was reduced to 10 Torr over approximately 60 minutes while maintaining the same temperature, and then the reduced pressure was maintained. 2 Hours after the start of the pressure reduction, the pressure was brought back to normal pressure by use of a nitrogen gas, and then a polymer thus generated was taken out. The number average molecular weight of the obtained resin was 11,000, $T_s$ was 203°C, and $T_i$ was 253°C. The obtained liquid crystal polymer was cooled with liquid nitrogen followed by freeze drying, and by controlling the pulverization time, fine powder having average particle diameter of 23 μm, and the maximum particle diameter of 111 μm was obtained. It was referred to as (III-4).

<Thermal conductive filler>

(IV-1) Alumina powder (AS-50 manufactured by Showa Denko K.K., thermal conductivity of product itself: 30 W/(m·K), volume average particle diameter: 9 μm, electrically insulating)
(IV-2) Aluminum nitride mixture powder (TFZ-A02P manufactured by Toyo Aluminum K.K., thermal conductivity of product itself: 170 W/(m·K), volume average particle diameter: 1.5 μm, and FAN-f30.8 manufactured by Furukawa Denshi Co., Ltd., volume average particle diameter: 30 μm, in volume ratio of 3 : 7)
(IV-3) Aggregated boron nitride powder (FP-70 manufactured by Denka Company Limited, thermal conductivity of product itself: 60 W/(m·K), volume average particle diameter: 70 μm, electrically insulating)

<Solvent>

(V-1) Cyclohexanone
(V-2) Toluene

[Example 1]

The epoxy compound (I-1) and the curing agent (II-1) were dissolved, at blending ratio to have equivalent ratio of 1 between the epoxy compound and the curing agent functional group, in the solvent (V-1). Subsequently, the fine

powder (III-1) of liquid crystal polymer and the thermal conductive filler (IV-1) were added to the solution. Composition is shown in Table 1. The liquid crystal polymer composition which has been obtained by kneading with three rolls was applied on a heat resistant release film made of aluminum to have thickness of 150 μm. The resultant was dried for 30 minutes at 90°C, and after overlapping it such that the resin layer is present inside and passing it through a heat roll at 220°C, the fine powder of liquid crystal polymer was melt and crystallized. By removing the release film, a semi-cured thermally conductive film was obtained. Thereafter, on an aluminum plate as a board for heat dissipation which has thermal conductivity of 220 W/mK and thickness of 1 mm, the aforementioned semi-cured thermally conductive film was laminated. After additionally laminating copper foil with thickness of 35 μm on top of the laminate, heat press was carried out at conditions of 180°C × 2 hours, 4 MPa. According to the above, an electronic circuit board formed of a semi-cured thermally conductive film, a board for heat dissipation, and a conductive foil for forming a wiring pattern that is provided on top of the semi-cured thermally conductive film was produced. The results of various measurements are shown in Table 1.

[Example 2]

The epoxy compound (I-2) and the curing agent (II-1) were dissolved, at blending ratio to have equivalent ratio of 1 between the epoxy compound and the curing agent functional group, in the solvent (V-1). Subsequently, the fine powder (III-1) of liquid crystal polymer and the thermal conductive filler (IV-1) were added to the solution. Composition is shown in Table 1. The liquid crystal polymer composition which has been obtained by kneading with three rolls was applied on copper foil with thickness of 35 μm to have thickness of 250 μm. The resultant was dried for 30 minutes at 90°C to obtain a resin-adhered copper foil. On an aluminum plate as a board for heat dissipation which has thermal conductivity of 220 W/mK and thickness of 1 mm, the aforementioned resin-adhered copper foil was laminated such that the resin is in contact with the aluminum plate. According to heat press at conditions of 180°C × 2 hours, 4 MPa, an electronic circuit board was produced. The results of various measurements are shown in Table 1.

[Examples 3 to 5, Comparative Examples 1, 2]

A semi-cured thermally conductive film and electronic circuit board were obtained in the same manner as Example 1 except that the composition is modified to the composition shown in Table 1. The results of various measurements are shown in Table 1. There was a condition that, when the curing agent (II-2) is used, the blending amount was a catalytic amount, and only in Comparative Example 2, conditions for heat press was 200°C as the maximum temperature for using the facility, 2 hours, and 4 MPa.

[Example 6]

The epoxy compound (I-1) and the fine powder (III-3) of liquid crystal polymer were mixed with each other at volume ratio of 8 : 2. After obtaining a homogeneous liquid phase by heating and stirring at 190°C, the mixture was cooled to room temperature so as to obtain an epoxy resin composite in which the liquid crystal polymer is homogeneously precipitated. According to observation under an optical microscope, it was found that the maximum particle diameter of the liquid crystal polymer is 30 μm. The resulting epoxy resin composite was diluted with the solvent (V-2) such that the final solid matter concentration is 20% by weight, and then added with the curing agent (II-1) which has been weighed to have equivalent ratio of 1 between the epoxy compound (I-1) and the functional group, and the thermal conductive filler (IV-1) which has been weighed to be 70% by volume relative to the final cured product. The resultant was applied on copper foil with thickness of 35 μm to have thickness of 250 μm, and then dried for 30 minutes at 90°C to obtain a resin-adhered copper foil. On an aluminum plate as a board for heat dissipation which has thermal conductivity of 220 W/mK and thickness of 1 mm, the aforementioned resin-adhered copper foil was laminated such that the resin is in contact with the aluminum plate. According to heat press at conditions of 180°C × 2 hours, 4 MPa, an electronic circuit board was produced. The thermal conductivity was 7 W/mK, 90° peel strength was 8 N/cm, and there was no defective appearance after solder heat resistance test.

[Example 7]

The fine powder (III-3) of liquid crystal polymer was added to the solvent (V-1) such that the final solid matter concentration is 10% by weight, and after obtaining a homogeneous liquid phase by heating and stirring at 150°C, the mixture was cooled to room temperature so as to obtain a varnish in which the liquid crystal polymer is homogeneously precipitated. According to observation under an optical microscope, it was found that the maximum particle diameter of the liquid crystal polymer is 30 μm. The resulting varnish was added with the epoxy compound (I-1), which has been weighed to have the same volume ratio as the liquid crystal polymer (III-3) and a catalytic amount of the curing agent

(II-2) followed by stirring, and then dissolved in the solvent (V-1). The thermal conductive filler (IV-1) which has been weighed to be 70% by volume relative to the final cured product was added thereto. The resultant was applied on copper foil with thickness of 35 μm to have thickness of 250 μm, and then dried for 30 minutes at 90°C to obtain a resin-adhered copper foil. On an aluminum plate as a board for heat dissipation which has thermal conductivity of 220 W/mK and thickness of 1 mm, the aforementioned resin-adhered copper foil was laminated such that the resin is in contact with the aluminum plate. According to heat press at conditions of 180°C × 2 hours, 4 MPa, an electronic circuit board was produced. The thermal conductivity was 8.2 W/mK, 90° peel strength was 8 N/cm, and there was no defective appearance after solder heat resistance test.

By comparing Examples 1 and 2 with Comparative Example 1, it was found that, by containing a liquid crystal polymer, the thermal conductivity can be significantly increased while the 90° peel strength or heat resistance is maintained. When a thermal conductive filler with high thermal conductivity is used like Examples 3 and 4, the thermal conductivity of a cured product is increased more. When a slightly coarse and large liquid crystal polymer is used like Example 5, there may be a case in which uneven strength occurs in 90° peel strength evaluation as homogeneous dispersion of the liquid crystal polymer is not achieved, and lower peel strength as a mean value is yielded. When the liquid crystal polymer which forms a liquid crystal phase at 200°C or higher is used like Comparative Example 2, it was found that sufficient fluidity of a liquid crystal polymer is not obtained even at heat press conditions of 200°C so that lower 90° peel strength is yielded. By heating and dissolving in advance the liquid crystal polymer in the epoxy compound or solvent and dispersing the liquid crystal polymer by cooling to room temperature like Examples 6 and 7, the cured product can have high thermal conductivity without heating at a temperature at which the liquid crystal polymer is dissolved in a system of the epoxy compound and curing agent during the following process.

As it is found from the above evaluation results, according to the present disclosure, a semi-cured thermally conductive film having excellent thermal conductivity, bondability, low-temperature processability is obtained, and, by using the semi-cured thermally conductive film, an electronic circuit board having high thermal conductivity, reliability, and heat resistance can be obtained.

[Table 1]

| Volume ratio | Example 1 | Example 2 | Example 3 | Example 4 | Example 5 | Example 6 | Example 7 | Comparative Example 1 | Comparative Example 2 |
|---|---|---|---|---|---|---|---|---|---|
| Epoxy compound (I) + Curing agent (I I) | (I-1) + (II-1) 15 | (I-2) + (II-1) 24 | (I-3) + (II-2) 15 | (I-4) + (II-3) 25 | (I-1) + (I I-1) 15 | (I-1) + (II-1) 26.7 | (I-1) + (II-2) 15 | (I-1) + (II-1) 30 | Example 2 (I-1) + (II-1) 15 |
| Liquid crystal polymer (II I) | (III-1) 15 | (III-1) 6 | (III-3) 15 | (III-3) 25 | (III-2) 1 5 | (III-3) 3.3 | (III-3) 15 | 0 | (III-4) 15 |
| Thermally conductive filler (IV) | (IV-1) 70 | (IV-1) 70 | (IV-2) 70 | (IV-3) 50 | (IV-1) 70 | (IV-1) 70 | (IV-1) 70 | (IV-1) 70 | (IV-1) 70 |
| Solvent (V) Solid content {(I) + (II)} % by weight | (V-1) 20 | (V-1) 20 | (V-1) 20 | (V-1) 10 | (V-1) 20 | (V-2) 20 | (V-1) 10 | (V-1) 22 | (V-1) 20 |
| Thermal conductivity (W/mK) | 7.0 | 6.8 | 14 | 18 | 6.7 | 7 | 8.2 | 4.1 | 7.0 |
| 90° Peel strength (N/c m) | 10 | 8.5 | 7.8 | 4.0 | 6.2 Strength mismatch | 8 | 8 | 11 | 5. 0 |
| Solder heat resistance (280 °C × 3分) | No defective appearance | No defective appearance | No defective appearance | No defective appearance | No defective appearance | No defective appearance | No defective appearance | No defective appearance | No defective appearance |

Second Embodiment (according to the invention)

[Evaluation method]

Number average molecular weight: A sample solution was prepared by dissolving the resin in a mixed solvent that contains p-chlorophenol (manufactured by Tokyo Chemical Industry Co., Ltd.) and toluene in a volume ratio of 3 : 8 so as to have a concentration of 0.25% by weight. Polystyrene was used as a standard material, and a standard solution was prepared by carrying out the same operations. The measurement was carried out by using those solutions and high-temperature GPC (manufactured by Viscotek; 350 HT-GPC System) under conditions in which a column temperature was 80°C, and a flow rate was 1.00 mL/min. A differential refractometer (RI) was used as a detector.

Phase transition temperature: According to differential scanning calorimetry measurement (DSC measurement), first temperature increase/decrease is carried out at 10°C/min in a range of 50°C to 320°C, and from the peak top of an endothermic peak at the second temperature increase at 10°C/min, solid phase-to-liquid crystal phase transition point ($T_s$) and liquid crystal phase-to-isotropic phase transition point ($T_i$) were obtained.

Molding of test specimen: The resin or resin composition was subjected to drying for 15 minutes at 50°C by using a hot air dryer followed by vacuum drying by setting an oven at 90 degrees. After that, the resin composition was inserted from the top while the coarse surface of copper foil of 4 cm × 4 cm × thickness of 15 μm faces the resin side, and then a film shaped sample with 5 cm × 5 cm × thickness of 150-300 μm was heat-pressed for 30 seconds at 2 MPa by a press molding machine followed by 30 seconds at pressure of 5 MPa. At that time, the press temperature was set at 215°C. Furthermore, as for the resin or resin composition, the amount obtained for each sample was suitably used for press molding. After that, the product obtained by a reaction for 120 to 140 seconds at 180°C was used as a thermally cured resin composition for measuring the thermal conductivity and bonding strength.

Specific gravity: The resin composition after thermal curing was molded on a specimen of 0.2 to 0.6 gram, and the specific gravity was measured according to Archimedes' principle. Thermal conductivity: Copper foil was removed from the test specimen, and by using a square shaped sample of 10

mm × 10 mm in thickness 200 μm to 300 μm and a laser flash method thermal conductivity measuring device (manufactured by NETZSCH; LFA447), thermal conductivity in thickness direction at room temperature (25°C) and atmospheric pressure was measured.

Evaluation of bonding strength: After carrying out an etching treatment following masking of copper foil surface of the test specimen, which has been prepared by the above method, with a polyimide tape having width of 1 mm, 90° peeling test was carried out by using an Autograph (AGS-X 10N-10kN manufactured by SHIMADZU CORPORATION). From the measured results, a mean value of N = 4 was calculated for each.

[Production Example 4]

Into a sealing type reaction vessel equipped with a reflux condenser, a thermometer, a nitrogen introduction tube, and a stirring bar, 4,4'-dihydroxybiphenyl (compound having the unit (i)), sebacic acid (compound having the unit (ii)), and eicosane dioic acid (compound having the unit (iii)) were added as a raw material in a ratio of 50 : 25 : 25% by mol, respectively, and then 2.1 equivalents of acetic anhydride relative to 4,4'-dihydroxybiphenyl and a catalytic amount of sodium acetate were added. According to the reaction under normal pressure in an atmosphere of nitrogen at 145°C, a homogeneous solution was obtained, and thereafter, the temperature was raised to 250°C at 2°C/min while acetic acid was removed by distillation followed by stirring at 250°C for 1 hour for copolymerization. Subsequently, the pressure was reduced to 5 Torr over approximately 60 minutes while maintaining the same temperature, and then copolymerization was carried out by maintaining the reduced pressure. 1.5 Hours after the start of the pressure reduction, the pressure was brought back to normal pressure by use of a nitrogen gas, and then a polymer thus generated was taken out. As a result of evaluating each physical property of the obtained polymer, it was found that the number average molecular weight is 11920, thermal conductivity of the resin itself is 0.38 W/(m·K), $T_s$ is 128°C, and $T_i$ is 201°C.

[Production Example 5]

After flushing a 3-neck flask equipped with a stirring bar with nitrogen, 4,4'-dihydroxybiphenyl (compound having the unit (i)), sebacic acid (compound having the unit (ii)), and eicosane dioic acid (compound having the unit (iii)) were added as a raw material thereto in a ratio of 50 : 25 : 25% by mol, respectively, and then 2.2 equivalents of acetic anhydride relative to 4,4'-dihydroxybiphenyl and a catalytic amount of sodium acetate were added. According to the reaction under normal pressure in an atmosphere of nitrogen at 140°C, a homogeneous solution was obtained, and thereafter, the temperature was raised to 270°C at 2°C/min while acetic acid was removed by distillation followed by stirring at 270°C for 1 hour and 20 minutes for copolymerization. Subsequently, while maintaining the same temperature, the reduced pressure state was maintained using a diaphragm pump for copolymerization.

55 Minutes after the start of the pressure reduction, the pressure was brought back to normal pressure by use of a nitrogen gas, and then a polymer thus generated was taken out. As a result of evaluating each physical property of the obtained polymer, it was found that the number average molecular weight is 5800, thermal conductivity of the resin itself is 0.64 W/(m·K), $T_s$ is 94.6°C, and $T_i$ is 194°C.

[Examples 8 to 10, Comparative Examples 3, 4]

The component (A) and the component (E) were mixed with each other at the blending shown in Table 1 by using a pestle and mortar. After that, the mixture was blended with the component (D) and the component (B) which have been thermally dissolved with a suitable amount of toluene, the component (C), and the component (E) to prepare a suspension. The resin composition for an adhesive sheet which has been obtained accordingly was subjected to heat press at 215°C as described above to prepare a test specimen. Thermal curing after the heat press was carried out for 120 minutes at 180°C. It was found that Examples 8 to 10 have excellent thermal conductivity compared to Comparative Examples 3 and 4. When comparison is made among Examples 8 and 9, Example 10, and Comparative Examples 3 and 4, it was found that the thermal conductivity and bonding strength cannot be obtained simultaneously when any one of the components (A) to (D) is omitted. Each component shown in Table 1 is indicated in terms of parts by weight when the entire resin composition is taken as 100.

[Table 2]

| Component | Example 8 | Example 9 | Example 10 | Comparative Example 3 | Comparative Example 4 |
|---|---|---|---|---|---|
| (A) Thermoplastic resin 1 | 5.42 | - | 5.41 | - | - |
| Thermoplastic resin 2 | - | 5.42 | - | - | - |
| (B) Curable resin 1 | 1.24 | 1.24 | 3.54 | 8.92 | 6.67 |
| (C) Curing agent 1 | 0.0003 | 0.0003 | 0.0003 | 0.0002 | 0.0002 |
| (D) Elastomer 1 | 2.26 | 2.26 | - | - | 2.26 |
| (E) Inorganic filler 1 | 91.05 | 91.05 | 91.05 | 91.05 | 91.05 |
| Thermal conductivity (W/mK) | 7.2 | 8.2 | 9.1 | 6.6 | 6.2 |
| Bonding strength(N/cm) | 3.7 | 3.7 | 2.3 | 2.8 | 3.1 |
| Thermoplastic resin 1 Production Example 4<br>Thermoplastic resin 2 Production Example 5<br>Curable resin 1 HP-4032D (DIC Corporation)<br>Curing agent 1 4-ethyl-2-methyl-imidazole<br>(Wako Pure Chemical Industries, Ltd.)<br>Elastomer 1 SIBSTAR 062T (KANEKA CORPORATION)<br>Inorganic filler 1 Alumina AS-400 (Showa Denko K.K.) | | | | | |

## Claims

1. A resin composition containing the following (A), (B), (C), (D), and (E):

(A) a thermoplastic resin which forms a liquid crystal phase at 190°C or lower, measured as indicated in the description, and contains as a main chain structure,

40 to 60% by mol of a unit (i) having a biphenyl group represented by General Formula (4)

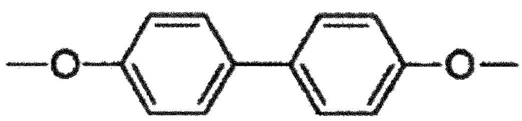

(4)

5 to 40% by mol of a unit (ii) represented by General Formula (5)

$-CO-R_3-CO-$ (5)

(wherein $R_3$ represents a linear divalent substituent group which has main chain atom number of 4 to 12 and may contain a branch), and
5 to 40% by mol of a unit (iii) represented by General Formula (6)

$-CO-R_4-CO-$ (6)

(wherein $R_4$ represents a linear divalent substituent group which has main chain atom number of 8 to 26 and may contain a branch, in which the main chain atom number is different from that of $R_3$)
((4) to (6) total 100% by mol),

(B) a curable resin,
(C) a curing agent,
(D) an elastomer, and
(E) an inorganic filler.

**2.** The resin composition according to claim 1, wherein the main chain atom number of $R_3$ and $R_4$ in the above general formulae (5) and (6) is an even number.

**3.** The resin composition according to claim 1 or 2, wherein the thermoplastic resin is a resin with a number average molecular weight of 4000 to 70000, wherein the number average molecular weight is measured by high-temperature GPC as set out in the specification.

**4.** The resin composition according to any one of claims 1 to 3, wherein (E) the inorganic filler is at least one compound selected from a group consisting of aluminum oxide, magnesium oxide, boron nitride, aluminum nitride, silicon nitride, aluminum hydroxide, magnesium hydroxide, and diamond.

**5.** The resin composition according to any one of claims 1 to 3, wherein (E) the inorganic filler is at least one compound selected from a group consisting of graphite, carbon nanotube, carbon fiber, electrically conductive metal powder, electrically conductive metal fiber, soft magnetic ferrite, and zinc oxide.

**6.** The resin composition according to any one of claims 1 to 5, wherein the amount of component (E) is, in terms of the volume ratio between the resins, the total of the components (A) to (D), and the component (E), 40 : 60 to 20 : 80.

**7.** The resin composition according to any one of claims 1 to 6, wherein component (D) is selected from a styrene-butadiene block copolymer, a styrene-ethylene/butylene-styrene block copolymer, a styrene-isoprene-styrene block copolymer, a styrene-isobutylene-styrene copolymer, a styrene-isobutylene copolymer, a polybutadiene, and a styrene-(ethylene-ethylene/propylene)-styrene block copolymer.

**8.** An adhesive sheet containing the resin composition described in any one of claims 1 to 7.

## Patentansprüche

**1.** Eine Harzzusammensetzung, enthaltend die folgenden (A), (B), (C), (D) und (E):

(A) ein thermoplastisches Harz, welches eine Flüssigkristallphase bei 190°C oder niedriger bildet, gemessen wie in der Beschreibung angegeben, und
als eine Hauptkettenstruktur folgendes enthält

40 bis 60 Mol-% einer Einheit (i) mit einer Biphenylgruppe, dargestellt durch die allgemeine Formel (4)

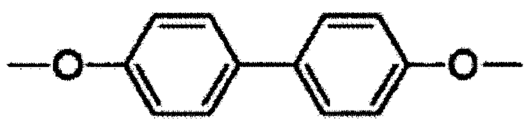 (4)

5 bis 40 Mol-% einer Einheit (ii), dargestellt durch die allgemeine Formel (5)

$$-CO-R_3-CO- \quad (5)$$

(wobei $R_3$ eine lineare zweiwertige Substituentengruppe darstellt, welche eine Atomzahl in der Hauptkette von 4 bis 12 aufweist und eine Verzweigung enthalten kann) und
5 bis 40 Mol-% einer Einheit (iii), dargestellt durch die allgemeine Formel (6)

$$-CO-R_4-CO- \quad (6)$$

(wobei $R_4$ eine lineare zweiwertige Substituentengruppe darstellt, welche eine Atomzahl in der Hauptkette von 8 bis 26 aufweist und eine Verzweigung enthalten kann, in welcher sich die Atomzahl in der Hauptkette von der in $R_3$ unterscheidet) ((4) bis (6) eine Gesamtmenge von 100 Mol-% ergeben),

(B) ein härtbares Harz,
(C) ein Härtungsmittel,
(D) ein Elastomer und
(E) einen anorganischen Füllstoff.

2. Die Harzzusammensetzung gemäß Anspruch 1, wobei die Atomzahl in der Haupkette von $R_3$ und $R_4$ in den oben stehenden Formeln (5) und (6) eine gerade Zahl ist.

3. Die Harzzusammensetzung gemäß Anspruch 1 oder 2, wobei das thermoplastische Harz ein Harz mit einem Zahlenmittel des Molekulargewichts von 4000 bis 70000 ist, wobei das Zahlenmittel des Molekulargewichts durch Hochtemperatur-GPC gemessen wird, wie in der Beschreibung dargestellt.

4. Die Harzzusammensetzung gemäß einem der Ansprüche 1 bis 3, wobei (E) der anorganische Füllstoff mindestens eine Verbindung, ausgewählt aus einer Gruppe bestehend aus Aluminiumoxid, Magnesiumoxid, Bornitrid, Aluminiumnitrid, Siliciumnitrid, Aluminiumhydroxid, Magnesiumhydroxid und Diamant, ist.

5. Die Harzzusammensetzung gemäß einem der Ansprüche 1 bis 3, wobei (E) der anorganische Füllstoff mindestens eine Verbindung, ausgewählt aus einer Gruppe bestehend aus Graphit, einer Kohlenstoffnanoröhre, einer Kohlenstofffaser, elektrisch leitfähigem Metallpulver, elektrisch leitfähiger Metallfaser, weichmagnetischem Ferrit und Zinkoxid, ist.

6. Die Harzzusammensetzung gemäß einem der Ansprüche 1 bis 5, wobei die Menge der Komponente (E), bezogen auf das Volumenverhältnis zwischen den Harzen, der Gesamtmenge der Komponenten (A) bis (D) und der Komponente (E), 40 : 60 bis 20 : 80 beträgt.

7. Die Harzzusammensetzung gemäß einem der Ansprüche 1 bis 6, wobei die Komponente (D) ausgewählt ist aus einem Styrol-Butadien-Blockcopolymer, einem Styrol-Ethylen/Butylen-Styrol-Blockcopolymer, einem Styrol-Isopren-Styrol-Blockcopolymer, einem Styrol-Isobutylen-Styrol-Copolymer, einem Styrol-Isobutylen-Copolymer, einem Polybutadien und einem Styrol-(Ethylen-Ethylen/Propylen)-Styrol-Blockcopolymer.

8. Eine Klebefolie, enthaltend die Harzzusammensetzung wie in einem der Ansprüche 1 bis 7 beschrieben.

## Revendications

1. Composition de résine contenant les (A), (B), (C), (D) et (E) suivants :

(A) une résine thermoplastique qui forme une phase de cristaux liquides à 190°C ou moins, mesurée comme indiqué dans la description,
et qui contient, en tant que structure de chaîne principale,

40 à 60 % en moles d'un motif (i) ayant un groupe biphényle représenté par la formule générale (4)

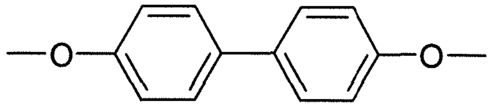

(4)

5 à 40 % en moles d'un motif (ii) représenté par la formule générale (5)

$-CO-R_3-CO-$ (5)

(dans laquelle $R_3$ représente un groupe substituant divalent linéaire qui a un nombre d'atomes de chaîne principale de 4 à 12 et qui peut contenir une ramification), et
5 à 40 % en moles d'un motif (iii) représenté par la formule générale (6)

$-CO-R_4-CO-$ (6)

(dans laquelle $R_4$ représente un groupe substituant divalent linéaire qui a un nombre d'atomes de chaîne principale de 8 à 26 et qui peut contenir une ramification, ayant un nombre d'atomes de chaîne principale différent de celui de $R_3$),
((4) à (6) représentant au total 100 % en moles),

(B) un agent durcissable,
(C) un agent durcisseur,
(D) un élastomère, et
(E) une charge inorganique.

2. Composition de résine selon la revendication 1, dans laquelle le nombre d'atomes de chaîne principale de $R_3$ et $R_4$ dans les formules générales (5) et (6) ci-dessus est un nombre pair.

3. Composition de résine selon la revendication 1 ou 2, dans laquelle la résine thermoplastique est une résine ayant une masse moléculaire moyenne en nombre de 4 000 à 70 000, dans laquelle la masse moléculaire moyenne en nombre est mesurée par GPC à température élevée comme indiqué dans le fascicule.

4. Composition de résine selon l'une quelconque des revendications 1 à 3, dans laquelle (E) la charge inorganique est au moins un composé choisi dans l'ensemble constitué par l'oxyde d'aluminium, l'oxyde de magnésium, le nitrure de bore, le nitrure d'aluminium, le nitrure de silicium, l'hydroxyde d'aluminium, l'hydroxyde de magnésium, et le diamant.

5. Composition de résine selon l'une quelconque des revendications 1 à 3, dans laquelle (E) la charge inorganique est au moins un composé choisi dans l'ensemble constitué par le graphite, les nanotubes de carbone, les fibres de carbone, la poudre de métal électriquement conducteur, les fibres de métal électriquement conducteur, la ferrite magnétique douce, et l'oxyde de zinc.

6. Composition de résine selon l'une quelconque des revendications 1 à 5, dans laquelle la quantité du composant (E) est, en termes du rapport en volume entre les résines, le total des composants (A) à (D), et le composant (E), de 40/60 à 20/80.

7. Composition de résine selon l'une quelconque des revendications 1 à 6, dans laquelle le composant (D) est choisi parmi un copolymère séquencé de styrène-butadiène, un copolymère séquencé de styrène-éthylène/butylène-styrène, un copolymère séquencé de styrène-isoprène-styrène, un copolymère de styrène-isobutylène-styrène, un copolymère de styrène-isobutylène, un polybutadiène, et un copolymère séquencé de styrène-(éthylène-éthylène/propylène)-styrène.

8. Feuille adhésive contenant la composition de résine décrite dans l'une quelconque des revendications 1 à 7.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011033815 A
- JP 2008150525 A
- WO 2015083523 A